(19) Europäisches Patentamt
European Patent Office
Office européen des brevets

(11) EP 2 860 895 B1

(12) **EUROPEAN PATENT SPECIFICATION**

(45) Date of publication and mention of the grant of the patent:
**14.09.2016 Bulletin 2016/37**

(51) Int Cl.:
***H04L 1/00*** *(2006.01)*

(21) Application number: **13306407.1**

(22) Date of filing: **14.10.2013**

(54) **Apparatus and method for Iteratively decoding a received signal**

Vorrichtung und Verfahren zur iterativen Decodierung eines empfangenen Signals

Appareil et procédé pour décoder itérativement un signal reçu

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**15.04.2015 Bulletin 2015/16**

(73) Proprietor: **ALCATEL LUCENT**
**92100 Boulogne-Billancourt (FR)**

(72) Inventor: **Schmalen, Laurent**
**70435 Stuttgart (DE)**

(74) Representative: **Wetzel, Emmanuelle**
**Alcatel-Lucent**
**Intellectual Property Business Group**
**70430 Stuttgart (DE)**

(56) References cited:
**WO-A2-2010/136930**
**US-A1- 2013 262 084**
**US-B1- 8 190 962**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 860 895 B1

## Description

Embodiments generally relate to communication systems and, in particular, to apparatuses and methods for decoding signals.

### Background

This section introduces aspects that may be helpful in facilitating a better understanding of embodiments of the present invention. Accordingly, the statements of this section are to be read in this light and are not to be understood as admissions about what is in the prior art or what is not in the prior art.

The combination of channel coding and modulation is a well-studied topic in the field of communications engineering. An example scheme of an iterative Forward Error Correction (FEC) on segmented words is described in US 2013/0262084 A1. In some of the practical systems employed nowadays - especially in optical communications - a pragmatic coding and modulation scheme denoted Bit Interleaved Coded Modulation (BICM) is employed: the binary output of a binary channel encoder is interleaved and then modulated and transmitted over a channel. It has been shown that with square constellation formats, such as Quadrature Phase Shift Keying (QPSK) or 16-Quadrature amplitude modulation (16-QAM) and Gray mappings, this approach may closely approach the modulation constrained capacity. However, if other modulation formats are used or if the channel imposes additional impairments to the signal, such as, for example, inter-symbol interference or phase ambiguities that need to be combated using differential coding, or Multiple-Input Multiple-Output (MIMO) transmissions, these impairments may lead to a performance penalty.

### Summary

Some simplifications may be made in the following summary, which is intended to highlight and introduce some aspects of the various example embodiments, but such simplifications are not intended to limit the scope of embodiments. Detailed descriptions of one or more preferred exemplary embodiments adequate to allow those of ordinary skill in the art to make and use the inventive concepts will follow in later sections.

According to a first aspect, embodiments provide a method for iteratively decoding a received signal. The received signal comprises encoded information symbols. The method includes detecting estimates of encoded information symbols corresponding to the received signal as a-priori information for a decoder. An iteration of the method includes generating, as extrinsic information, estimates of decoded information symbols corresponding to at least a part of the received signal using the a-priori information and the decoder. Further, the iteration includes updating estimates of encoded information symbols corresponding to the part of the received signal using the received signal and the extrinsic information corresponding to the part of the received signal. The updated estimates are provided to the decoder as updated a-priori information for a subsequent iteration.

In one or more embodiments, estimates or reliability information of encoded information symbols may be detected for the whole received signal in a first decoding iteration. In a subsequent decoding iteration the estimates or reliability information may be updated only for the part of the received signal corresponding to the subsequent iteration.

In some embodiments, estimates or reliability information of encoded information symbols corresponding to different parts of the received signal may be updated in different decoding iterations. For example, estimates or reliability information for encoded information symbols corresponding to a first part of the received signal may be updated in an even iteration. Estimates or reliability information for encoded information symbols corresponding to a second part of the received signal may be updated in an odd iteration, or vice versa. In some implementations a vector comprising the received signal may be sub-divided into a plurality of sub-vectors. Updating the estimates or reliability information in the iteration may comprise detecting reliability information for encoded information symbols corresponding to one of the sub-vectors.

According to yet a further aspect, embodiments provide an apparatus for iteratively decoding a received signal. The received signal comprises encoded information symbols. The apparatus includes a detector to detect estimates of encoded information symbols corresponding to the received signal to obtain a-priori information for a decoder. For a decoding iteration, the apparatus includes a decoder to generate, as extrinsic information, estimates of decoded information symbols corresponding to at least a part of the received signal using the a-priori information. The apparatus further includes a loop detector to update estimates for encoded information symbols corresponding to the part of the received signal using the received signal and the extrinsic information corresponding to said part of the received signal, and to provide the updated estimates corresponding to the part to the decoder as updated a-priori information for a subsequent decoding iteration.

Some embodiments comprise a digital control circuit installed within the apparatus. Such a digital control circuit, e.g., a Digital Signal Processor (DSP), a Field-Programmable Gate Array (FPGA), an Application-Specific Integrated Circuit (ASIC), or a general purpose processor, needs to be programmed accordingly. Hence, yet further embodiments also provide a computer program having a program code for performing embodiments of the power control method, when the computer program is executed on a programmable hardware device.

Brief description of the Figures

Some embodiments of apparatuses and/or methods will be described in the following by way of example only, and with reference to the accompanying figures, in which

| | |
|---|---|
| Fig. 1a | illustrates an example of a BICM with Iterative Decoding (BICM-ID) scheme; |
| Fig. 1b | shows an example communication system for iterative decoding of a forward error correction (FEC) code; |
| Fig. 1c | illustrates example communication systems with a Multiple-Input Multiple Output (MIMO) or Single-Input Single-Output (SISO) channel exhibiting inter-symbol interference and with turbo equalization at a receiver; |
| Figs. 2a-c | illustrate examples of different unrolled decoding pipelines; |
| Fig. 3 | illustrates a qualitative convergence behavior of an iterative decoding; |
| Fig. 4 | schematically illustrates an embodiment of an apparatus for iteratively decoding a received signal; |
| Fig. 5a | shows a schematic of a first embodiment of an apparatus for iteratively decoding a received signal; |
| Fig. 5b | shows a schematic of a second embodiment of an apparatus for iteratively decoding a received signal; |
| Fig. 5c | shows schematics of conventional apparatuses for iteratively decoding a received signal; |
| Fig. 5d | shows a schematic of a third embodiment of an apparatus for iteratively decoding a received signal; |
| Fig. 6 | illustrates a comparison of detector executions in a conventional versus a proposed scheme; |
| Figs. 7a, b | illustrates an improvement by an embodiment of partial detector execution; and |
| Figs. 8a, b | illustrates improvements by a further embodiment of partial detector execution. |

Description of Embodiments

Various example embodiments will now be described more fully with reference to the accompanying drawings in which some example embodiments are illustrated. In the figures, the thicknesses of lines, layers and/or regions may be exaggerated for clarity.

Accordingly, while example embodiments are capable of various modifications and alternative forms, embodiments thereof are shown by way of example in the figures and will herein be described in detail. It should be understood, however, that there is no intent to limit example embodiments to the particular forms disclosed, but on the contrary, example embodiments are to cover all modifications, equivalents, and alternatives falling within the scope of the invention. Like numbers refer to like or similar elements throughout the description of the figures.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein have the same meaning as commonly understood by one of ordinary skill in the art to which example embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

With iterative decoding and detection, the aforementioned Bit Interleaved Coded Modulation (BICM) performance penalty may be in principle fully recovered if an unlimited number of iterations between a demodulator/detector and a channel decoder can be allowed at the receiver. An iterative exchange of extrinsic information permits to approach the channel capacity of the given modulation scheme. If however the number of iterations is limited to a finite value, the performance penalty can only be partially recovered. As the execution of a demodulator/differential decoder/equalizer/MIMO detector/MIMO equalizer is usually computationally relatively complex, a small number of detector executions can only be tolerated in practical receivers. Note that subsequently the term "detector" will be used to denote any of the mentioned demodulator/differential decoder/equalizer/MIMO detector/MIMO equalizer, or the like. That is to say, a detector serves for detecting estimates of encoded information symbols in the received signal, while a decoder serves for decoding the encoded information symbols. As a Forward Error Correction (FEC) code a Low-Density Parity-Check (LDPC) code may be chosen for example, due to its favorable implementation properties.

Some block diagrams of various communication systems to which embodiments of the present invention may be employed are shown in Figs. 1a to 1c.

**Fig. 1a** shows for example a BICM with Iterative Decoding (BICM-ID) scheme for higher order modulation formats.

Fig. 1a shows a signal processing chain of a communication system 100, e.g., an optical communication system, which can also be provided by some embodiments. The signal processing exemplarily starts at the upper left corner of Fig. 1a with an outer encoder, which may for example be a Turbo product encoder, or the like. The task of the outer encoder 102 is to add redundancy to an input information word 101, which may comprise digitized data. A signal output 103 of the outer encoder 102 may then be input into an interleaver 104, which interleaves the data. The interleaving may be adapted to an error characteristic, which is introduced in a transmission channel 112 later on such that burst errors may be resolved by subsequent de-interleaving 120 to enable enhanced error correction at an outer decoder 122. In the exemplary communication system 100 resulting interleaved data 105 may then be input into an LDPC encoder 106 to obtain (encoded) LPDC code words 107 before being assigned to transmission symbols 109 by a mapping entity 108. The transmission symbols 109 are then modulated by modulator 110 and transmitted through the transmission channel 112. The modulation 110 may comprise a conversion from base band, which can be complex, to a transmission band as well as a conversion from a digital/electrical to an optical signal, for example. In the present example an optical conversion and thus an optical transmission channel 112 is assumed. Note that the blocks 102 to 110 make up a transmitter of the communication system 100. This may be an optical transmitter. Note that wireless or wireline communication systems are possible as well.

At the receiver the received transmission symbols 109, i.e., the LPDC code words, may be demodulated 114, where the demodulation 114 may include optical/electrical conversion and conversion from the transmission band to the complex base band. Fig. 1a illustrates a processing path between the demodulation 114 and a subsequent de-interleaver 120 involving a demapper 116 and an LDPC decoder 118. The demapper 116 detects estimates 117 of LPDC encoded symbols or bits based on the demodulated signal 115. Hence, the demapper 116 may be regarded as a detector for encoded symbols. The estimates 117 may be detected in form of so-called soft information comprising reliability information on the encoded symbols or bits. The reliability information may be expressed in terms of likelihood values or log-likelihood ratios (LLRs). This soft information 117 from the demapper/detector 116 may also be regarded as a-priori probability information for the subsequent LDPC decoder 118.

In some implementations, a clipping function may optionally be applied to the output of the demapper/detector 116. The clipping function limits the likelihood values (extrinsic probability information from the demapper/detector 116) to enable a better decoding performance of the subsequent LDPC decoder 118. The performance of the iterative decoder can be improved by the limitation, as an upper limit of the likelihood values can be assumed based on a known occurrence or probability of occurrence of a phase slip. For example, the probability of a phase slip for a given optical channel may be in a range around $10^{-3}$. Hence, all likelihood values may be limited to $\log((1-10^{-3})/10^{-3}) \approx 6.91$, as this is the highest certainty that can be achieved. In other words, a residual error rate of $10^{-3}$ is known and considered by using an according the clipping function. This is only a simplified view. The clipping function can be a pure clipping function that saturates all values above a certain threshold to that value or it can be a smooth function given by an equation $f(x) = \log(((1-P_s)\cdot\exp(x) + P_s)/(P_s.\exp(x) + (1-P_s)))$, wherein $P_s$ denotes the probability of a phase slip. The clipped output of the clipping function may then be input into the LDPC decoder 118, which will be explained in more detail below.

The LDPC decoder 118 may then determine updated likelihood values 117' as extrinsic probability information, which may be fed back to the demapper/detector 116 as priori probability information for a next iteration of demapper/detector 116, which is indicated by the arrows between the demapper/detector 116 and the LDPC decoder 118. If the clipping function is applied to the extrinsic output 117 of the detector 116, it also has to be applied likewise to the likelihood values 117' computed by the LDPC decoder 118. The circular shaped arrow indicates that a number of iterations may be carried out, wherein the likelihood values are updated by one of the demapper 116 and the LDPC decoder 118. The decoding iteration may be terminated by a parity check criterion. An output 119 from the LDPC decoder 118 may then be de-interleaved by de-interleaver 120 before being provided to the outer decoder 122 for outer decoding in line with the above described outer encoding 102.

**Fig**. **1b** illustrates a further possible implementation of a communication system 130 comprising iterative decoding of a Forward Error Correction (FEC) code with a differential code, for example used in the context of optical communications.

The signal processing exemplarily starts with a channel encoder 132, which may be any known block or convolutional encoder. The task of the channel encoder 132 is to add redundancy to an input information word 131, which may comprise digitized data. A signal output 133 of the channel encoder 132 may then be input to a mapping entity 134 for mapping tuples of FEC encoded bits to transmission symbols 135. In some embodiments the mapping entity 134 may perform a Gray mapping, for example. The transmission symbols 135 may then be differentially encoded by a differential encoder 136 to prevent or limit the effect of phase slips, which may occur due to undetectable phase noise events in the subsequent transmission channel 112. Strictly speaking, the phase slips do not occur in the transmission channel 112 as such but are due to phase noise events that cause a phase offset correction algorithm to make a wrong decision. The phase noise correction algorithm is part of the digital signal processing chain that is not explicitly shown in Fig. 1b and that can be considered as being either part of the transmission channel 112 or as being part of the demodulation 114. Differentially encoded data symbols 137 may be derived using a linear feedback shift register which comprises a delay element. The transfer function of the linear feedback shift register performing the differential encoding rule is given in the z-domain as $H(z) = 1/(1-z^{-1})$. In the BPSK case, the differential encoder 136 can be represented as an accumulator computing $y_i = y_{i-1} \oplus x_i$, where "$\oplus$" denotes the modulo-2 addition or the eXclusive OR (XOR) operation, respectively. The differentially encoded transmission symbols 137 are then modulated by modulator 110 and transmitted through the transmission channel 112. In the transmission channel 112, e.g., an optical, a wireless, a wireline or a powerline transmission channel, phase slips can occur due to the inability of a receiver to handle large phase noise, i.e., the phase may jump or suddenly change by a certain angle. This angle may correspond to 180° or $\pi$ in a BPSK case; it may correspond predominantly to 90° or $\pi/2$ in the QPSK case. Such a phase slip may result in erroneous symbols being detected subsequently. The differential coding 136 limits the effect of a phase slip to the symbol which is detected subsequently to the phase slip, as the difference to the previous symbol only is affected by the phase slip. However, since the difference to the next symbol is not affected by the phase slip (assuming only a single phase slip to occur), the differential encoding 136 limits the effect of a phase slip. As the phenomenon of phase slips is well known in the art further details will be omitted not to obscure the principles of embodiments.

At the receiver the received encoded data symbols may be demodulated 114, where the demodulation 114 may include optical/electrical conversion and conversion from the transmission band to the complex base band. Following the processing path, the demodulated base band symbols may be differentially decoded 138, which may result in soft information 139, i.e., information on estimated symbols or bits and reliability information thereon, which can, for example, be expressed in terms of likelihood values or log-likelihood values. The differential decoder 138 hence detects estimates 139 of FEC encoded symbols or bits and may therefore be regarded as a detector. The estimates 139 may be detected in form of soft information comprising reliability information on the FEC encoded symbols or bits. This extrinsic soft information 139 from the differential decoder / detector 138 may also be denoted as a-priori probability information for the channel decoder 140. The channel decoder 140 may then determine updated likelihood values 139’ as extrinsic probability information, which may be fed back to the differential decoder / detector 138 as priori probability information for a next iteration of differential decoder / detector 138, which is indicated by the arrows between the differential decoder / detector 138 and the channel decoder 140. The circular shaped arrow indicates that a number of iterations may be carried out, wherein the likelihood values are updated by one of the decoders 138, 140. A clipping function as described above may be applied to the likelihood values 139 and 139’ to limit the effect of phase slips in the iterative decoder.

**Fig. 1c** shows example communication systems 150, 160 with a Multiple-Input Multiple Output (MIMO) channel (right) or a Single-Input Single-Output (SISO) channel exhibiting inter-symbol interference and with turbo equalization at the receiver. Functional blocks that have been explained before will not be detailed again.

In the systems 150, 160 of Fig. 1c, a demodulated base band signal 151, 161 may be equalized 152, 162, which may result in soft information 153, 163, i.e., information on estimated symbols or bits and reliability information thereon, which can, for example, be expressed in terms of likelihood values or log-likelihood values. The equalizers 152, 162 hence detect estimates of FEC encoded symbols or bits and may therefore be regarded as detectors. The estimates may be detected in form of soft information 153, 163 comprising reliability information on the FEC encoded symbols or bits. This soft information 153, 163 from the equalizer 152, 162 may also be denoted as a-priori probability information for the channel decoder 140. The channel decoder 140 may then determine updated likelihood values 153’, 163’, which may be fed back to the equalizer/detector 152, 162 as priori probability information for a next iteration of the equalizer/detector 152, 162, which is indicated by the arrows between the equalizer/detector 152, 162 and the channel decoder 140. The circular shaped arrow indicates that a number of iterations may be carried out, wherein the likelihood values are updated by one of the equalizer/detector 152, 162 and the decoder 140.

In optical receivers operating at high data rates (e.g., 100 Gbps, 400 Gbps or 1TBit/s), the implementation of such iterative receivers may be unrolled. This means that instead of performing *L* iterations, *L* instances of a decoder may be placed in a kind of pipelined way. Due to Very-Large-Scale Integration (VLSI) limitations (e.g., chip size, chip area, etc.), the number *L* usually is kept relatively small (for example in the order of 10 to 20). As the complexity of a single detector execution may usually exceed the complexity of a channel decoder execution, the number of detector executions may be smaller than *L*. We assume here that the number of detector executions amounts to $L_{det} = \lceil L/F \rceil$, with F denoting a number of channel decoder executions for each detector execution and $\lceil x \rceil$ denoting the smallest integer larger or equal than *x*. Usually the detector executions may be spread equidistantly.

**Fig. 2a to 2c** show some examples of different unrolled decoding pipelines for *F* = 1 (Fig. 2a), *F* = 2 (Fig. 2b), and *F* = 3 (Fig. 2c). It has been shown that placing the detector 202 after *F* executions of a channel decoder 204 is not necessarily the optimal choice, but has a performance very close to the optimum.

**Fig. 3** illustrates a qualitative convergence behavior of an iterative decoding system similar to Fig. 1a employing LDPC codes and with *F* = 2. That means that a detector for a whole LDPC code word, e.g., comprising a demapper 116, is executed in every second LDPC decoder iteration. It can be seen that whenever the detector is executed, the Bit Error Rate (BER) drops by a relatively large amount, whereas the BER only decreases by a small amount if the detector 116 is not executed and the LDPC decoder 118 has to use old detector information. It is therefore desirable to achieve a decoding and convergence behavior with a possibly more uniform decrease in BER. By this more uniform decrease in BER, a lower overall BER after the total allowed amount of iterations is expected and the influence of those iterations that do not get fed with new detector information is enhanced.

It is one idea of embodiments to only partially execute a detector in each decoder iteration, such that the detector operates only on a subset of the received data, respectively. Thereby a size of the subset determines the complexity of the iterative receiver. With embodiments the convergence of the decoder may be faster and potentially less iterations may be needed. This may allow further reducing the complexity of the receiver.

According to one aspect, embodiments provide an apparatus 400 for iteratively decoding a received signal 401. An example implementation of such an apparatus 400 is schematically illustrated in the block diagram of **Fig. 4.**

The received signal 401 comprises encoded information symbols. Thereby the received signal 401 may have been transmitted to the receiver apparatus 400 via a communication channel, such as a wireless or optical channel, for example. The information symbols may have been encoded via one of the aforementioned FEC encoding schemes, such as by means of a convolutional and/or block encoding scheme. One particular example may be a binary or higher-order LDPC encoding scheme at the transmitter side.

The apparatus 400 includes a detector 402 to initially detect estimates or reliability information 403 for encoded information symbols of the received signal 401 to obtain a-priori information for a decoder 404 which is coupled to the detector 402. In other words, the detector 402 may initially detect estimates 403 of encoded information symbols which may by fed to the decoder 404 as a-priori information. For said initial detection no feedback from a decoder may be used yet. The estimates 403 may be soft estimates, for example expressed as LLRs, in some embodiments. Examples for the detector 402 include symbol-to-binary demappers, SISO- or MIMO channel equalizers, differential decoders, demodulators, etc., which output estimates or reliability information 403 for transmitted information symbols inherent to the received signal 401.

For a decoding iteration *l*, the apparatus 400 also includes a decoder 404 to generate estimates or reliability information 405-*l* of decoded information symbols corresponding to at least a part of the received signal 401 using detected a-priori information 403 from the detector 402, or using a-priori information 403-*l* in subsequent iterations. The estimates 405-*l* may be also regarded as extrinsic information for the decoded information symbols corresponding to at least a part of the received signal 401. The decoder 404 may be a channel decoder for decoding FEC encoded symbols or bits based on the detected estimates 403. Examples of the decoder 404 include any of known block or convolutional decoders, in particular so-called soft-input soft-output decoders. Some examples are Viterbi decoders, Turbo decoders, or LDPC decoders, just to name a few possible implementations.

The apparatus 400 further includes a loop detector 406 to update estimates or reliability information 403-*l* of encoded information symbols corresponding to the part of the received signal based on the received signal 401 and the extrinsic information 405-(*l*-1) of the previous iteration *l*-1 corresponding to said part of the received signal 401. The loop detector 406 is executed in the *l*-th iteration of the decoder 404. The loop detector 406 then provides the updated estimates or reliability information 403-*l* to the decoder 404 as updated a-priori information for a subsequent or upcoming decoding iteration. The loop detector 406 may be regarded as a soft-input soft output detector in some embodiments. Examples for the loop detector 406 include symbol-to-binary de-mappers, SISO- or MIMO channel equalizers, differential decoders, demodulators, etc., which output updated estimates or reliability information 403-*l* for a part of the transmitted information symbols inherent to the received signal 401. The loop detector 406 may differ in so far from the initial detector 402 in that it additionally uses the extrinsic information 405-(*l*-1) provided by the FEC decoder 404 as a-priori information for determining updated estimates or reliability information of encoded information symbols corresponding to only a part of the received signal 401. This will become more apparent in the sequel.

Note that the apparatus 400 may perform a corresponding method for iteratively decoding the received signal 401. The method includes (initially) detecting estimates or reliability information 403 of encoded information symbols corresponding to the whole received signal 401 as (initial) a-priori information for the decoder 404. At iteration í, the method includes generating, as extrinsic information, estimates or reliability information 405-1 of decoded information symbols corresponding to at least a part of the received signal 401 using the a-priori information 403 and the decoder 404. Note that also in the first iteration, the decoder generates extrinsic information for use in the subsequent iterations. Further, the l-th iteration includes updating estimates 403-1 of encoded information symbols corresponding to the part of the received signal using the received signal 401 and the extrinsic information 405-(1-1) corresponding to the part of the received signal 401. The updated estimates 403-1 are provided to the decoder 404 as updated a-priori information for a subsequent iteration.

For further explanation of embodiments let us introduce some notation: Let z = ($z_1$,...,$Z_{N'}$) denote a receive vector of N' complex received samples. Hence, the vector z = ($z_1$, .,$z_{N'}$) may be regarded as or derived from the received signal 401. Further, let $e_{[i]}$ = (e[l-1]".... e[l-1],$_N$) denote a vector of N extrinsic information samples computed by the channel decoder 404 after the (l-1)-th iteration. Hence, the vector e[l-1] = (e[l-1],1..., e[l-1],$_N$) may be regarded as the extrinsic information 405-(1-1) for the decoded information symbols corresponding to at least a part of the received signal 401. Further, the vector a[l] = ($a_{[l]}$,1, ...., $a_{[l],N}$) denotes the a-priori information 403-1 computed by the loop detector 406 in the 1-th iteration. We furthermore have N' = [N/J] where the J is the modulation compression factor (e.g., for QPSK, J = 2, for 16-QAM, J = 4, etc...). Hence, J denotes the number of bits per transmit symbol. That is to say, the encoded information symbols may have been modulated according to an M-ary modulation scheme, with M > 2. Detecting or updating the estimates or reliability information 403, 403-1 for encoded information symbols may also include demodulating the received signal or a part thereof in accordance with the M-ary modulation scheme.

Before describing the concept behind embodiments we may distinguish between two different kinds of detectors: the initial detector 402 may operate purely on the received channel values z and compute the necessary information 403, which may be expressed in terms of Log-Likelihood Ratios (LLRs) for the encoded information symbols corresponding to the received signal 401, for example. The second kind of detector 406 may take as its inputs the received values z (401) as well as additional a-priori knowledge 405-(*l*-1) from the channel decoder 404, which may be channel decoder extrinsic information. Throughout this specification the detector 406 is denotes as *"loop detector"* to emphasize that it is executed inside the iterative decoding loop. This detector implementation may be more complex than the implementation of the initial detector 402 as it has to cope with additional a-priori information 405-(*l*-1) - usually complicating employed algorithms.

According to embodiments, the loop detector 406 may be executed partly after each channel decoding iteration, such that an overall complexity of the detector comprising the initial detector 402 and the loop detector 406 is identical or at least comparable to a conventional case. For that partial loop detector execution, the received signal 401 or the received sample vector **z** may be sub-divided into *F* sub-vectors $\mathbf{z}^{[p,1]}$,...$\mathbf{z}^{[p,F]}$ of length *N'/F* =: *U.* Hence, in some embodiments the vector **z** comprising the received signal 401 may be sub-divided into a plurality of sub-vectors. The loop detector 406 may be executed at iteration *l* (*l* > 1) on the part of the received signal 401 expressed by sub-vector $\mathbf{z}^{[p,f(l)]}$, with *f*(*l*) being a function selecting a certain part depending on the current iteration *l*. One example of such a selecting function is *f*(l) = 1 + (*l* mod *F*). Updating the reliability information 403-*l* in the *l*-th iteration may hence comprise detecting estimates or reliability information for encoded information symbols corresponding to one of the sub-vectors $\mathbf{z}^{[p,1]}$,...$\mathbf{z}^{[p,F]}$. Note that *l* > 1, as in the first iteration (*l* = 1), the initial detector 402 may be executed without the loop detector 406. The initial detector 402 operates on the complete receive vector **z.** Only in the subsequent iterations the loop detector 406 becomes necessary. In other words, in a first iteration (*l* =1) the estimates or reliability information 403 is detected for the whole received signal vector **z** including one or more code words. In a subsequent iteration (*l* > 1) the reliability information 407 may be updated only for the part of the received signal **z** corresponding to the subsequent iteration.

A simplified receiver schematic for both cases *F* = 2 and *F* = 3 is shown in **Figures 5a and 5b,** respectively.

In the example of Fig. 5a the received sample vector **z** is sub-divided into two sub-vectors $\mathbf{z}^{[p,1]}$ and $\mathbf{z}^{[p,2]}$. In the example of Fig. 5b the received sample vector **z** is sub-divided into three sub-vectors $\mathbf{z}^{[p,1]}$, $\mathbf{z}^{[p,2]}$ and $\mathbf{z}^{[p,3]}$. The received sample vector **z** may include a whole code word. The initial detector 402 operates on the whole received vector **z** in the first iteration, respectively. Starting from the second decoder iteration, the loop or partial detector 406 is executed in each iteration but operates only on a subset of the received data and also only on a subset of extrinsic information from the decoder 404. In the example of Fig. 5a the loop detector 406 operates on $\mathbf{z}^{[p,1]}$ in the second iteration and on $z^{[p,2]}$ in the third iteration. In the fourth iteration the loop detector 406 again operates on $\mathbf{z}^{[p,1]}$, etc. Hence, in some embodiments the estimates or reliability information 403-*l* for encoded information symbols corresponding to different parts $\mathbf{z}^{[p,1]}$, $\mathbf{z}^{[p,2]}$ of the received signal **z** are updated in subsequent iterations. In the particular embodiment of Fig. 5a the reliability information (soft information) for the first part $\mathbf{z}^{[p,1]}$ of the received signal is updated in even iterations and the reliability information for the second part $\mathbf{z}^{[p,2]}$ of the received signal is updated in odd iterations. Of course it may be vice versa as well.

Usually the channel decoder 404 needs to compute specific extrinsic information that is fed back as a-priori information to the channel decoder 404. In some embodiments only the extrinsic information corresponding to the partial receive vector $\mathbf{z}^{[p,l]}$ needs to be computed, thus simplifying the computation of extrinsic information by the factor *F*.

In embodiments related to optical communications, there are several possibilities for generating the partial subvector $\mathbf{z}^{[p,l]}$ :

> For example, if $F = 2$, we may naturally assign the received value of each polarization to a partial sub-vector $\mathbf{z}^{[p,l]}$, if we use polarization division multiplexing, i.e., dual-polarization mode with coherent reception. Hence, if the received signal is a polarization division multiplexed signal, a first part of the received signal may correspond to a first polarization, while a second part of the received signal may corresponds to a second polarization. Consequently, in some embodiments the x-polarization may be loop detected even iteration steps, and the y-polarization may be loop detected in odd iterations numbers, after an initial detection of both polarizations.

Many LDPC codes that are implemented today are so-called Quasi-Cyclic (QC) LDPC codes. They have a parity check matrix **H** with a structure that allows for inherent parallelization of the LDPC decoder and leads to an efficient encoder realization. QC-LDPC codes may be constructed using a so-called lifting matrix **A.** The parity check matrix **H** may be constructed from the lifting matrix **A** by replacing each element of **A** with either an all-zero matrix of size $S \times S$ or a permutation matrix, e.g., a cyclically permuted identity matrix, of size $S \times S$. We adhere to the following notation: *S* denotes the lifting factor, i.e., the size of the all-zero or cyclically shifted identity matrix. If the entry of **A** at row *m* and column *i* corresponds to a predetermined value, e.g., $A_{m,i} = -1$, then the all-zero matrix of size $S \times S$ is used, and if $A_{m,i} \geq 0$, $A_{m,i}$ may denote how many cyclic right shifts of the identity matrix are performed. If dim(**H**) = $M \times N$, then dim(**A**) = $M' \times N'$, with $M' = M/S$ and $N' = N/S$. We furthermore define the set $\mathcal{N}_{\mathbf{A}}(m)$ to denote the positions of the non "-1" entries (or any other entry denoting a void replacement) in the *m*-th row of **A**, i.e., $\mathcal{N}_{\mathbf{A}}(m) = \{i: A_{m,i} \neq -1\}$.

Let us illustrate the construction of QC-LDPC codes by a small (artificial) example with a lifting matrix of size dim(**A**) = 3 × 5 and a lifting factor of *S* = 5 (leading to dim(**H**) = *S*·dim(**A**) = 15x25. This corresponds to a code of design rate *r* = 0.4, or an overhead of 150%, respectively).

$$\mathbf{A} = \begin{pmatrix} -1 & 0 & 1 & 1 & 2 \\ 2 & -1 & 4 & 2 & 1 \\ 1 & 3 & -1 & 3 & 1 \end{pmatrix} \rightarrow \mathbf{H} = \left(\begin{array}{ccccc|ccccc|ccccc|ccccc|ccccc}
&&&& & 1&&&& & &1&&& & &1&&& & &&1&& \\
&&&& & &1&&& & &&1&& & &&1&& & &&&1& \\
&&&& & &&1&& & &&&1& & &&&1& & &&&&1 \\
&&&& & &&&1& & &&&&1 & &&&&1 & 1&&&& \\
&&&& & &&&&1 & 1&&&& & 1&&&& & &1&&& \\
\hline
&&1&& & &&&& & &&&&1 & &&1&& & &1&&& \\
&&&1& & &&&& & 1&&&& & &&&1& & &&1&& \\
&&&&1 & &&&& & &1&&& & &&&&1 & &&&1& \\
1&&&& & &&&& & &&1&& & 1&&&& & &&&&1 \\
&1&&& & &&&& & &&&1& & &1&&& & 1&&&& \\
\hline
&1&&& & &&&1& & &&&& & &&&1& & &1&&& \\
&&1&& & &&&&1 & &&&& & &&&&1 & &&1&& \\
&&&1& & 1&&&& & &&&& & 1&&&& & &&&1& \\
&&&&1 & &1&&& & &&&& & &1&&& & &&&&1 \\
1&&&& & &&1&& & &&&& & &&1&& & 1&&&&
\end{array}\right)$$

Note that for the sake of clarity only the Is are show in the description **of H.** Generally the value *S* corresponds to the parallelism that can be implemented in a QC-LDPC decoder.

For QC-LDPC codes the input of an LDPC decoder, i.e., the code word or LDPC frame may be partitioned into *N*/*S* chunks of size *S* each. The advantage of this code design is that *S* check nodes and variable node updates can be computed in parallel, and that there is a local independence between *S* neighboring bits in a chunk. In some embodiments, according to a first possibility (for $F = 2$) partial detection may be applied to a half of the chunks in an LDPC frame. In some embodiments, according to a second possibility each chunk may be subdivided into *S*/*F* parts and partial detection is applied to each of these chunks. In this way each chunk and thus each check group may get at least partially updated in every decoder iteration. Hence, in some embodiments the information symbols may have been encoded according to an LDPC encoding rule. Therefore, generating the extrinsic information 405-*l* for the decoded information symbols may be based a corresponding LDPC decoding rule. In such embodiments the received signal $z$ 401 may comprise an LDPC frame. The LDPC frame may comprise a plurality of $S$ chunks. In some embodiments a part $\mathbf{z}^{[p,1]}$ or $\mathbf{z}^{[p,2]}$ of the received signal may correspond to a part of the received LDPC frame including one or more chunks. Alternatively, the part $\mathbf{z}^{[p,1]}$ or $\mathbf{z}^{[p,2]}$ of the received signal $\mathbf{z}$ 401 may correspond to a part of one or more chunks. That is to say, the first part $\mathbf{z}^{[p,1]}$ may comprise a first part of a first chunk, a first part of a second chunk, a first part of a third chunk, etc. Likewise, the second part $\mathbf{z}^{[p,2]}$ may comprise a second part of the first chunk, a second part of the second chunk, a second part of the third chunk, etc.

Usually, in optical communications, a so-called layered (or row-) decoding approach may be employed due to its advantageous convergence properties. Here, an LDPC decoder continuously updates received LLR values with the goal to compute LLRs that approximate the Maximum A Posteriori (MAP) values. The received vector of LLRs y, corresponding to the output of the (initial) detector, may therefore be copied to an a-posteriori memory $\hat{y}$ of LDPC frame size N, which is continuously updated. The decoding operation in the row-layered decoder comprises three acts, where a) the first act prepares the input data, b) the second act performs the computation of new extrinsic data and c) the final act updates the LLR a-posteriori memory. The row-layered LDPC decoder carries out the three steps sequentially for each row of the parity check matrix **H.** After all rows have been considered, a single decoding iteration has been carried out. The LDPC decoder usually carries out several iterations, where the number depends on the available resources.

In the following, we briefly describe the aforementioned three acts for a single row $m$ of **H.** The first step a) comprises computing $\mathrm{card}(\mathcal{N}(m)) = d_c$ (card = cardinality) temporary values $t_{m,i}$, with

$$t_{m,i} = \hat{y}_i - e_{m,i}^{(l)} \qquad \text{for all } i \in \mathcal{N}(m)$$

for all non-zero entries (indexed by $i$) of the $m$-th row of **H.** Thereby the set $\mathcal{N}(m)$ denote the positions of the 1s in the $m$-th row of **H,** i.e., $\mathcal{N}(m) = \{i\colon H_{m,i} = 1\}$. The super-script ($l$) denotes the iteration counter, i.e., the operations are carried out in the $l$-th iteration of the row-layered LDPC decoding procedure. The value $e_{m,i}$ is the (stored) extrinsic memory for row $m$ and variable $\hat{y}_i$. At the beginning of the decoding of a single LDPC frame (code word), all $e_{m,i}$ may be initialized by zero (i.e., $e_{m,i}^{(1)} = 0$) and then continuously updated. Note that in total only $\sum_m \mathrm{card}(\mathcal{N}(m))$ memory locations may be used for storing the $e_{m,i}$. If the code is check-regular, $\sum_m \mathrm{card}(\mathcal{N}(m)) = Md_c$. In the second step, the extrinsic memory for the subsequent iteration ($l$+1) is updated using the $t_{m,i}$ according to

$$\begin{aligned} e_{m,i}^{(l+1)} &= 2\cdot\tanh^{-1}\left(\prod_{j\in\mathcal{N}(m)\setminus\{i\}} \tanh\left(\frac{t_{m,j}}{2}\right)\right) \qquad \text{for all } i \in \mathcal{N}(m) \\ &= \left[\prod_{j\in\mathcal{N}(m)\setminus\{i\}} \mathrm{sign}\left(t_{m,j}\right)\right]\cdot\phi\left(\sum_{j\in\mathcal{N}(m)\setminus\{i\}} \phi\left(\left|t_{m,j}\right|\right)\right), \quad \text{with } \phi(\tau) = -\log\left(\tanh\left(\frac{\tau}{2}\right)\right) = \log\left(\frac{e^{\tau}+1}{e^{\tau}-1}\right), \end{aligned}$$

where a log-domain expression may be more suitable for practical implementations, as the multiplication is replaced by an addition and instead of two functions tanh(·)/tanh$^{-1}$(·), only a single function $\phi$(·) needs to be implemented (or approximated by a look-up table). The product (or the sum) of the above equation may be carried out over all entries in $\mathcal{N}(m)$ except the one under consideration $i$. This is indicated by the notation $\mathcal{N}(m)$\{i}. For instance, in an example, where $\mathcal{N}_{\mathbf{A}}\ \mathcal{N}$ may be computed corresponding to

$$\begin{aligned} e_{5,13}^{(l+1)} &= 2\cdot\tanh^{-1}\left(\prod_{j\in\mathcal{N}(5)\setminus\{13\}} \tanh\left(\frac{t_{m,j}}{2}\right)\right) = 2\cdot\tanh^{-1}\left(\prod_{j\in\{1;5;9;21\}} \tanh\left(\frac{t_{m,j}}{2}\right)\right) \\ &= 2\cdot\tanh^{-1}\left(\tanh\left(\frac{t_{5,1}}{2}\right)\tanh\left(\frac{t_{5,5}}{2}\right)\tanh\left(\frac{t_{5,9}}{2}\right)\tanh\left(\frac{t_{5,21}}{2}\right)\right). \end{aligned}$$

The derivation of the preceding equation for the extrinsic update is beyond the scope of this specification.

Usually, if high LDPC decoder throughputs shall be achieved, the computation of $e_{m,i}$ can be further simplified. An often employed simplification of the log-domain equation, which we will consider in the following, is the so-called min-sum approximation which leads to

$$e_{m,i}^{(l+1)} = \left[ \prod_{j \in \mathcal{N}(m) \setminus \{i\}} \text{sign}(t_{k,j}) \right] \min_{j \in \mathcal{N}(m) \setminus \{i\}} | t_{m,j} | \qquad \text{for all } i \in \mathcal{N}(m)$$

As this second act b) computes the output of the parity check node *m* of the check node in the graphical representation of LDPC codes, it is frequently denoted by check node operation.

Finally, in the last decoding act c), the LLR memory may be updated corresponding to

$$\hat{y}_i = t_{m,i} + e_{m,i}^{(l+1)} \qquad \text{for all } i \in \mathcal{N}(m)$$

and the LDPC decoder may continue with decoding row $m$+1 or, if $m = M$, restarts at $m$ = 1 (next iteration).

Figures 5c and 5d illustrate various implementations of a layered decoder concept in an unrolled decoding pipeline with iterative detection and/or decoding. In the layered decoding approach, the LDPC decoder 404 is an engine that operates on the a-posteriori memory related to the code words, manipulating and refining the a-posteriori memory in each decoding iteration. The detectors 402' usually employed in iterative detection and decoding usually have an extrinsic interface, which means that a conversion between a-posteriori and extrinsic domain may be performed when interfacing between LDPC decoder 404 and detector 402'. A conventional layered decoding scheme for $F$ = 1 and $F$ = 2 is shown in **Fig 5c.** The interfacing between a-posteriori and extrinsic domain can be carried out by simple additions and subtractions if the decoding reliabilities are represented as log-likelihood ratios. Note that the detectors 402' illustrated in Fig. 5c operate on the full received signal vector z each time they are executed.

**Fig. 5d** shows an embodiment of the proposed partial detector execution scheme for a system with a layered LDPC decoder 404 in the a-posteriori domain and with an extrinsic partial loop detector 406 for the case when $F$ = 2. In the example implementation of Fig. 5d the received sample vector **z** is sub-divided into two sub-vectors $\mathbf{z}^{[p,1]}$ and $\mathbf{z}^{[p,2]}$. The initial detector 402 operates on the whole received vector **z** in the first iteration ($l$ = 1) in order to provide an initial estimate (for example LLRs) of the LDPC code word to the LDPC decoder 404. Starting from the second decoder iteration ($l$ > 1), the loop or partial detector 406 is executed in each iteration but operates only on a subset of the received data and also only on a subset of extrinsic information delivered by the LDPC decoder 404. In the example of Fig. 5d the first loop detector 406 operates on $\mathbf{z}^{[p,1]}$ and the corresponding extrinsic decoder information of the first LDPC decoder iteration. The second loop detector 406 operates on $\mathbf{z}^{[p,2]}$ and the corresponding extrinsic decoder information in the of the second LDPC decoder iteration. in the output of the third LDPC decoder iteration is used in the third loop detector 406 execution, which again operates on $\mathbf{z}^{[p,1]}$, etc. Hence, in some embodiments the estimates or reliability information for encoded information symbols corresponding to different parts $\mathbf{z}^{[p,1]}$, $\mathbf{z}^{[p,2]}$ of the received signal **z** are updated in subsequent iterations. In the particular embodiment of Fig. 5d, the reliability information (soft information) for the first part $\mathbf{z}^{[p,1]}$ of the received signal is updated in even iterations and the reliability information for the second part $\mathbf{z}^{[p,2]}$ of the received signal is updated in odd iterations. Of course it may be vice versa as well.

Let us illustrate some performance improvements of embodiments by a simulation example. We assume that we use a system with differential QPSK transmission and use an iterative differential recovery scheme. We assume that the equivalent channel model is an Additive White Gaussian Noise (AWGN) channel with randomly occurring phase slips that have a probability of occurrence of 0.005. Due to complexity constraints, we allow 7 (or 9) layered LDPC iterations to be carried out at the receiver. Additionally, the number of differential detector executions is constrained to be 4 (or 5, if 9 overall iterations are carried out). In the conventional system, the detector is executed in iterations 1, 3, 5, 7, (9). In the embodiment with the partial execution scheme, we first execute the initial differential detector over the whole block of data, which is necessary in order to trigger the decoding. Afterwards, we execute the loop detector in each iteration over half the received LDPC frame. In a dual-polarization case, one could think of executing the loop detector in each even iteration for one polarization and in odd iterations for the other polarizations. After 7 (or 9) iterations, the total number of processed received samples by the differential detector is identical in both cases. The detector executions are shown for the case with 7 overall iterations in **Fig. 6.** The code that was used was a quasi-cyclic LDPC code but we placed a random interleaver between code and differential encoder and used only a single polarization for transmission.

In **Figs. 7a and 7b,** we compare the bit error rates after both decoding schemes (conventional and partial detection) after 7 overall iterations (Fig. 7a) and after 9 overall iterations (Fig. 7b). We can clearly observe the advantage of the partial detector executions in terms of convergence speed.

If a total number of operations allowed to be executed by the detector is fixed by an energy efficiency budget, embodiments can achieve additional performance gains by introducing the concept of partial detector execution. One idea of partial detector execution according to embodiments is to execute the loop detector only partly after each decoder iteration such that the overall complexity of the detector (measured in processed samples) comprising initial detector 402 and partial loop detector 406 is identical to a conventional case, as for example illustrated by Fig. 5c.

Let us consider an 8-QAM star constellation example with $L_{tot}$ = 12 total decoder iterations and $L_{det}$ = 4 detector executions. This means that a conventional loop detector 402' is scheduled only every third iteration in average. Overall this implies 165 possible scheduling options. A BER performance for the two best scheduling options is illustrated in **Figs. 8a, b.** Fig. 8a shows the evolution of the BER over the iterations for the two best schedules and an embodiment of the partial detector execution scheme.

The previous 8-QAM example may be extended to include partial detector execution according to embodiments. The benefits are shown by means of an AWGN simulation. As Ltot = 12, we may set F = 3. In order to have a fair comparison, we do not execute the partial loop detector 406 in the last two iterations. In that setup the total number of operations carried out by initial detector 402 and the partial loop detector 406 is identical in all compared examples (except full BICM-ID, where $L_{det}$ = 12). Fig. 8b shows the simulation results and we observe a performance gain of around 0.05 dB with an embodiment of partial loop detector execution. We can see that a performance loss to the full BICM-ID case ($L_{det}$ = $L_{tot}$ = 12, i.e., executing the detector 402' in or after every decoder iteration) is only about 0.1 dB, with only one fourth of the total detector complexity.

With embodiments of the present invention we have further possibilities for code and system design. The interleaver between LDPC code and detector may have a strong influence on the convergence of the proposed system. The interleaver in the case of the partial detector execution may be designed such that the convergence speed is maximized. It is known that an optimized mapping of code (especially systematic and parity) bits to certain positions in the modulation bits can significantly alter the convergence behavior, especially if the number of overall executions is constrained. With the partial detector executions, we may design the interleaver such that the convergence speed is maximized.

In the simulation examples, we have used an LDPC code designed for the conventional case with F = 1. Already the case F > 1 with conventional detector execution scheme can pose some new challenges for code design (especially if the number of iterations is constrained). With the partial detector execution scheme new challenges arise for the code design. We can tailor for instance a Multi-edge-type LDPC code specially optimized for this application. With convergence analysis tools, the code can be designed such that the benefit from the partial detector executions is maximized.

With some embodiments the SNR performance of optical transport systems may be improved. Further, faster convergence speeds of the iterative detection and decoding stage may be achieved compared to existing solutions. This may have two main implications: The first implication is that higher coding gains may be achieved without increasing the total overall VLSI implementation complexity of the decoder. The second implication is that the decoding VLSI implementation complexity (e.g., chip area, number of gates/memory) may be decreased with a smaller coding gain penalty.

The description and drawings merely illustrate the principles of the invention. It will thus be appreciated that those skilled in the art will be able to devise various arrangements that, although not explicitly described or shown herein, embody the principles

of the invention and are included within its scope, which is solely defined by the claims. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks shall be understood as functional blocks comprising circuitry that is adapted for performing a certain function, respectively. Hence, a "means for s.th." may as well be understood as a "means being adapted or suited for s.th.". A means being adapted for performing a certain function does, hence, not imply that such means necessarily is performing said function (at a given time instant).

Functions of various elements shown in the figures, including any functional blocks may be provided through the use of dedicated hardware, such as "a processor", "a controller", etc. as well as hardware capable of executing software in association with appropriate software. Moreover, any entity described herein as functional block, may correspond to or be implemented as "one or more modules", "one or more devices", "one or more units", etc. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the Detailed Description, where each claim may stand on its own as a separate embodiment. While each claim may stand on its own as a separate embodiment, it is to be noted that - although a dependent claim may refer in the claims to a specific combination with one or more other claims - other embodiments may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

It is further to be noted that methods disclosed in the specification or in the claims may be implemented by a device having means for performing each of the respective steps of these methods.

Further, it is to be understood that the disclosure of multiple steps or functions disclosed in the specification or claims may not be construed as to be within the specific order. Therefore, the disclosure of multiple steps or functions will not limit these to a particular order unless such steps or functions are not interchangeable for technical reasons. Furthermore, in some embodiments a single step may include or may be broken into multiple sub steps. Such sub steps may be included and part of the disclosure of this single step unless explicitly excluded.

## Claims

1. Method for iteratively decoding a received signal (**z**; 401) comprising encoded information symbols, the method comprising

   detecting (402) estimates (403) of encoded information symbols corresponding to the received signal (401) to obtain a-priori information for a decoder (404),
   wherein an iteration (*l*) of the method comprises:

      generating by the decoder (404), as extrinsic information (405), estimates for decoded information symbols corresponding to at least a part ($\mathbf{z}^{[p,1]}$; $\mathbf{z}^{[p,2]}$) of the received signal (z; 401) using the a-priori information (403) ;
      updating (406) estimates (403-*l*) of encoded information symbols corresponding to the part ($z^{[p,1]}$; $z^{[p,2]}$) of the received signal (**z**; 401) using the received signal (**z**; 401) and the extrinsic information (405-(*l*-1)) corresponding to the part ($\mathbf{z}^{[p,1]}$; $\mathbf{z}^{[p,2]}$) of the received signal; and
      providing the updated estimates (403-*l*) to the decoder (404) as updated a-priori information for a subsequent iteration,
      **characterized in that**
      estimates (403-*l*) of encoded information symbols corresponding to different parts ($\mathbf{z}^{[p,1]}$; $\mathbf{z}^{[p,2]}$) of the received signal (**z**; 401) are updated in different iterations.

2. The method of claim 1, wherein estimates (403-*l*) of encoded information symbols corresponding to a first part ($\mathbf{z}^{[p,1]}$) of the received signal (**z**; 401) are updated in an even iteration and wherein estimates (403-*l*) of encoded information symbols corresponding to a second part ($\mathbf{z}^{[p,2]}$) of the received signal (**z**; 401) are updated in an odd iteration, or vice versa.

3. The method of claim 1, wherein the information symbols have been encoded according to an LDPC encoding rule, and wherein generating the extrinsic information for the decoded information symbols is based on a corresponding LDPC decoding rule.

4. The method of claim 3, wherein the LDPC decoding rule uses row layered LDPC decoding.

5. The method of claim 3, wherein the received signal (**z**; 401) comprises an LDPC frame, the LDPC frame comprising a plurality of chunks, wherein

   the part ($\mathbf{z}^{[p,1]}$; $\mathbf{z}^{[p,2]}$) of the received signal (**z**; 401) corresponds to a part of the LDPC frame including one or more chunks, or wherein
the part ($\mathbf{z}^{[p,1]}$; $\mathbf{z}^{[p,2]}$) of the received signal ($\mathbf{z}$; 401) corresponds to a part of one or more chunks.

**6.** The method of claim 1, wherein a vector comprising the received signal ($\mathbf{z}$; 401) is sub-divided into a plurality of sub-vectors ($\mathbf{z}^{[p,1]}$; $\mathbf{z}^{[p,2]}$), and wherein updating the estimates (403-*l*) in the iteration comprises detecting reliability information for encoded information symbols corresponding to one of the sub-vectors ($\mathbf{z}^{[p,1]}$; $\mathbf{z}^{[p,2]}$).

**7.** The method of claim 1, wherein in a first iteration of the method the estimates (403) are detected for the whole received signal ($\mathbf{z}$; 401), and wherein in a subsequent iteration the estimates (403-*l*) are updated for a part ($\mathbf{z}^{[p,1]}$; $\mathbf{z}^{[p,2]}$) of the received signal ($\mathbf{z}$; 401) corresponding to the subsequent iteration only.

**8.** The method of claim 1, wherein the received signal ($\mathbf{z}$; 401) is a polarization division multiplexed signal, wherein a first part of the received signal corresponds to a first polarization, and wherein a second part of the received signal corresponds to a second polarization.

**9.** The method of claim 1, wherein the received signal ($\mathbf{z}$; 401) has been transmitted over an optical communication channel.

**10.** The method of claim 1, wherein the encoded information symbols have been modulated according to an *M*-ary modulation scheme, with $M > 2$, and wherein detecting or updating the estimates (403; 403-*l*) of encoded information symbols comprises demodulating the received signal or a part thereof in accordance with the *M*-ary modulation scheme.

**11.** The method of claim 1, wherein the information symbols are encoded and modulated according to a bit interleaved coded modulation scheme.

**12.** Computer program comprising a program code adapted to perform the method of claim 1, when the computer program is executed on a programmable hardware device.

**13.** Apparatus (400) for iteratively decoding a received signal ($\mathbf{z}$; 401) comprising encoded information symbols, the apparatus (400) comprising

a detector (402) to detect estimates (403) of encoded information symbols corresponding to the received signal (401) to obtain a-priori information for a decoder (404),
wherein for a decoding iteration (*l*) of the apparatus (400) comprises:

a decoder (404) to generate, as extrinsic information (405), estimates for decoded information symbols corresponding to at least a part ($z^{[p,1]}$ ; $z^{[p,2]}$ ) of the received signal (z; 401) using the a-priori information (403);
a loop detector (406) to update estimates (403-*l*) of encoded information symbols corresponding to the part ($\mathbf{z}^{[p,1]}$; $\mathbf{z}^{[p,2]}$) of the received signal (z; 401) using the received signal (z; 401) and the extrinsic information (405-(*l*-1)) corresponding to the part ($\mathbf{z}^{[p,1]}$; $\mathbf{z}^{[p,2]}$) of the received signal, and to provide the updated estimates (403-*l*) to the decoder (404) as updated a-priori information for a subsequent iteration,
**characterized in that**
the loop detector (406) is configured to update estimates (403-*l*) of encoded information symbols corresponding to different parts ($\mathbf{z}^{[p,1]}$; $\mathbf{z}^{[p,2]}$) of the received signal ($\mathbf{z}$; 401) in different iterations.

## Patentansprüche

**1.** Verfahren für die iterative Decodierung eines empfangenen Signals ($\mathbf{z}$; 401), umfassend codierte Informationssymbole, das Verfahren umfassend

Erkennen (402) von Schätzungen (403) codierter Informationssymbole, die dem empfangenen Signal (401) entsprechen, um A-Priori-Information für einen Decoder (404) zu erhalten,
wobei eine Iteration (*l*) des Verfahrens umfasst:

Erzeugen durch den Decoder (404), als extrinsische Information (405), von Schätzungen für decodierte Informationssymbole, die mindestens einem Teil ($\mathbf{z}^{[p,1]}$; $\mathbf{z}^{[p,2]}$) des empfangenes Signals (z; 401) entsprechen, unter Benutzen der A-Priori-Information (403);
Aktualisieren (406) von Schätzungen (403-*l*) codierter Informationssymbole, die dem Teil ($\mathbf{z}^{[p,1]}$; $\mathbf{z}^{[p,2]}$) des empfangenen Signals (**z**; 401) entsprechen, unter Benutzen des empfangenen Signals (**z**; 401) und der extrinsischen Information (405-(*l*-1)), die dem Teil ($\mathbf{z}^{[p,1]}$; $\mathbf{z}^{[p,2]}$) des empfangenen Signals entspricht; und
Bereitstellen der aktualisierten Schätzungen (403-*l*) für den Decoder (404) als aktualisierte A-Priori-Information für eine anschließende Iteration,
**dadurch gekennzeichnet, dass**
Schätzungen (403-*l*) codierter Informationssymbole, die verschiedenen Teilen ($\mathbf{z}^{[p,1]}$; $\mathbf{z}^{[p,2]}$) des empfangenen Signals (**z**; 401) entsprechen, in verschiedenen Iterationen aktualisiert werden.

**2.** Verfahren nach Anspruch 1, wobei die Schätzungen (403-*l*) codierter Informationssymbole, die einem ersten Teil ($\mathbf{z}^{[p,1]}$) des empfangenen Signals (**z**; 401) entsprechen, in einer geraden Iteration aktualisiert werden und wobei die Schätzungen (403-*l*) codierter Informationssymbole, die einem zweiten Teil ($\mathbf{z}^{[p,1]}$) des empfangenen Signals (**z**; 401) entsprechen, in einer ungeraden Iteration aktualisiert werden oder umgekehrt.

**3.** Verfahren nach Anspruch 1, wobei die Informationssymbole entsprechend einer LDPC-Codierregel codiert worden sind, und wobei das Erzeugen der extrinsischen Information für die decodierten Informationssymbole auf einer entsprechenden LDPC-Decodierregel basiert.

**4.** Verfahren nach Anspruch 3, wobei die LDPC-Decodierregel eine reihengeschichtete LDPC-Decodierung ist.

**5.** Verfahren nach Anspruch 3, wobei das empfangene Signal (z; 401) einen LDPC-Rahmen umfasst, wobei der LDPC-Rahmen eine Vielzahl von Blöcken umfasst, wobei

der Teil ($\mathbf{z}^{[p,1]}$; $\mathbf{z}^{[p,2]}$) des empfangenen Signals (**z**; 401) einem Teil des LDPC-Rahmens entspricht, einschließlich eines oder mehrerer Blöcke, oder wobei
der Teil ($\mathbf{z}^{[p,1]}$; $\mathbf{z}^{[p,2]}$) des empfangenen Signals (**z**; 401) einem Teil eines oder mehrerer Blöcke entspricht.

**6.** Verfahren nach Anspruch 1, wobei ein Vektor, der das empfangene Signal (z; 401) umfasst, in eine Vielzahl von Untervektoren ($\mathbf{z}^{[p,1]}$; $\mathbf{z}^{[p,2]}$) unterteilt ist, und wobei die Aktualisierung der Schätzungen (403-*l*) in der Iteration das Erkennen von Zuverlässigkeitsinformation für codierte Informationssymbole umfasst, die einem Untervektor ($\mathbf{z}^{[p,1]}$; $\mathbf{z}^{[p,2]}$) entsprechen.

**7.** Verfahren nach Anspruch 1, wobei in einer ersten Iteration des Verfahrens die Schätzungen (403) für das gesamte empfangene Signal (z; 401) erfasst werden, und wobei in einer anschließenden Iteration die Schätzungen (403-*l*) für einen Teil ($\mathbf{z}^{[p,1]}$; $\mathbf{z}^{[p,2]}$) des empfangenen Signals (**z**; 401) aktualisiert werden, die nur der anschließenden Iteration entsprechen.

**8.** Verfahren nach Anspruch 1, wobei das empfangene Signal (**z;** 401) ein Polarisationsmultiplexsignal ist, wobei ein erster Teil des empfangenen Signals einer ersten Polarisation entspricht und wobei ein zweiter Teil des empfangenen Signals einer zweiten Polarisation entspricht.

**9.** Verfahren nach Anspruch 1, wobei das empfangene Signal (**z**; 401) über einen optischen Kommunikationskanal übertragen wird.

**10.** Verfahren nach Anspruch 1, wobei die codierten Informationssymbole moduliert worden sind gemäß einem *M*-adischen Modulationsschema, mit $M > 2$, und wobei das Erkennen oder das Aktualisieren der Schätzungen (403; 403-*l*) der codierten Informationssymbole das Demodulieren des empfangenen Signals oder eines Teils davon in Einklang mit dem *M*-adischen Modulationsschema umfasst.

**11.** Verfahren nach Anspruch 1, wobei die Informationssymbole codiert und moduliert werden gemäß einem bitverschachtelten codierten Modufationsschema.

**12.** Computerprogramm, umfassend einen Programmcode, der ausgelegt ist zum Durchführen des Verfahrens nach Anspruch 1, wenn das Computerprogramm auf einer programmierbaren Hardwarevorrichtung ausgeführt wird.

**13.** Einrichtung (400) für die iterative Decodierung eines empfangenen Signals (z; 401), umfassend codierte Informationssymbole, wobei die Einrichtung (400) umfasst

einen Detektor (402), um die Schätzungen (403) der codierten Informationssymbole zu erkennen, die dem empfangenen Signal (401) entsprechen, um A-Priori-Information für einen Decoder (404) zu erhalten, wobei für eine Decodieriteration (*l*) die Einrichtung (400) umfasst:

einen Decoder (404) zum Erzeugen, als extrinsische Information (405), von Schätzungen für decodierte Informationssymbole, die mindestens einem Teil ($\mathbf{z}^{[p,1]}$; $\mathbf{z}^{[p,2]}$) des empfangenen Signals (z; 401) entsprechen, unter Benutzen der A-Priori-Information (403);
einen Schleifendetektor (406) zum Aktualisieren der Schätzungen (403-*l*) der codierten Informationssymbole, die dem Teil ($\mathbf{z}^{[p,1]}$; $\mathbf{z}^{[p,2]}$) des empfangenen Signals (z; 401) entsprechen, unter Benutzen des empfangenen Signals (z; 401) und der extrinsischen Information (405-(*l*-1)), die dem Teil ($\mathbf{z}^{[p,1]}$; $\mathbf{z}^{[p,2]}$) des empfangenen Signals entspricht, und zum Bereitstellen der aktualisierten Schätzungen (403-*l*) für den Decoder (404) als aktualisierte A-Priori-Information für eine anschließende Iteration,
**dadurch gekennzeichnet, dass**
der Schleifendetektor (406) konfiguriert ist zum Aktualisieren der Schätzungen (403-*l*) der codierten Informationssymbole, die verschiedenen Teilen ($\mathbf{z}^{[p,1]}$; $\mathbf{z}^{[p,2]}$) des empfangenen Signals (**z**; 401) in verschiedenen Iterationen entsprechen.

## Revendications

1. Procédé de décodage itératif d'un signal reçu (**z** ; 401) comprenant des symboles d'information codés, le procédé comprenant l'étape suivante :

détecter (402) des estimations (403) de symboles d'information codés correspondant au signal reçu (401) pour obtenir des informations a priori pour un décodeur (404),
dans lequel une itération (*l*) du procédé comprend les étapes suivantes :

générer par le décodeur (404), en tant qu'informations extrinsèques (405), des estimations pour les symboles d'information décodés correspondant à au moins une partie ($\mathbf{z}^{[p,1]}$ ; $\mathbf{z}^{[p,2]}$) du signal reçu (**z** ; 401) au moyen des informations a priori (403) ;
mettre à jour (406) les estimations (403-*l*) des symboles d'information codés correspondant à la partie ($\mathbf{z}^{[p,1]}$ ; $\mathbf{z}^{[p,2]}$) du signal reçu (**z** ; 401) au moyen du signal reçu (**z** ; 401) et des informations extrinsèques (405-(*l*-1)) correspondant à la partie ($\mathbf{z}^{[p,1]}$ ; $\mathbf{z}^{[p,2]}$) du signal reçu ; et
fournir les estimations (403-*l*) mises à jour au décodeur (404) en tant qu'informations a priori mises à jour pour une itération suivante,
**caractérisé en ce que**
les estimations (403-*l*) des symboles d'information codés correspondant à différentes parties ($\mathbf{z}^{[p,1]}$ ; $\mathbf{z}^{[p,2]}$) du signal reçu (z ; 401) sont mises à jour en différentes itérations.

2. Procédé selon la revendication 1, dans lequel les estimations (403-*l*) des symboles d'information codés correspondant à une première partie ($\mathbf{z}^{[p,1]}$) du signal reçu (**z** ; 401) sont mises à jour dans une itération paire et dans lequel les estimations (403-*l*) des symboles d'information codés correspondant à une seconde partie ($\mathbf{z}^{[p,2]}$) du signal reçu (**z** ; 401) sont mises à jour dans une itération impaire, ou vice-versa.

3. Procédé selon la revendication 1, dans lequel les symboles d'information ont été codés conformément à une règle de codage LDPC et dans lequel la génération des informations extrinsèques pour les symboles d'information décodés est basée sur une règle de décodage LDPC correspondante.

4. Procédé selon la revendication 3, dans lequel la règle de décodage LDPC utilise le décodage LDPC par couches.

5. Procédé selon la revendication 3, dans lequel le signal reçu (**z** ; 401) comprend une trame LDPC, la trame LDPC comprenant une pluralité de segments, dans lequel

la partie ($\mathbf{z}^{[p,1]}$ ; $\mathbf{z}^{[p,2]}$) du signal reçu (**z** ; 401) correspond à une partie de la trame LDPC comprenant un ou plusieurs segments, ou dans lequel
la partie ($\mathbf{z}^{[p,1]}$; $\mathbf{z}^{[p,2]}$) du signal reçu (**z** ; 401) correspond à une partie d'un ou plusieurs segments.

**6.** Procédé selon la revendication 1, dans lequel un vecteur comprenant le signal reçu (**z** ; 401) est subdivisé en une pluralité de sous-vecteurs ($\mathbf{z}^{[p,1]}$ ; $\mathbf{z}^{[p,2]}$), et dans lequel la mise à jour des estimations (403-*l*) dans l'itération consiste à détecter des informations de fiabilité pour les symboles d'information codés correspondant à l'un des sous-vecteurs ($\mathbf{z}^{[p,1]}$ ; $\mathbf{z}^{[p,2]}$).

**7.** Procédé selon la revendication 1, dans lequel dans une première itération du procédé, les estimations (403) sont détectées pour le signal reçu complet (**z** ; 401) et dans lequel dans une itération suivante, les estimations (403-*l*) sont mises à jour pour une partie ($\mathbf{z}^{[p,1]}$ ; $\mathbf{z}^{[p,2]}$) du signal reçu (**z** ; 401) correspondant uniquement à l'itération suivante.

**8.** Procédé selon la revendication 1, dans lequel le signal reçu (**z** ; 401) est un signal multiplexé par division en polarisation, dans lequel une première partie du signal reçu correspond à une première polarisation et dans lequel une seconde partie du signal reçu correspond à une seconde polarisation.

**9.** Procédé selon la revendication 1, dans lequel le signal reçu (**z**; 401) a été transmis par un canal de communication optique.

**10.** Procédé selon la revendication 1, dans lequel les symboles d'information codés ont été modulés conformément à un schéma de modulation *M*-aire, avec $M > 2$, et dans lequel la détection ou la mise à jour des estimations (403 ; 403-*l*) des symboles d'information codés consiste à démoduler le signal reçu ou une partie de celui-ci conformément au schéma de modulation *M*-aire.

**11.** Procédé selon la revendication 1, dans lequel les symboles d'information sont codés et modulés conformément à un schéma de modulation de codage par entrelaçage.

**12.** Programme informatique comprenant un code de programme conçu pour exécuter le procédé selon la revendication 1, lorsque le programme informatique est exécuté sur un dispositif matériel programmable.

**13.** Appareil (400) de décodage itératif d'un signal reçu (z; 401) comprenant des symboles d'information codés, l'appareil (400) comprenant

un détecteur (402) destiné à détecter des estimations (403) de symboles d'information codés correspondant au signal reçu (401) pour obtenir des informations a priori pour un décodeur (404),
dans lequel, pour une itération de décodage (*l*), l'appareil (400) comprend :

un décodeur (404) destiné à générer, en tant qu'informations extrinsèques (405), des estimations pour les symboles d'information décodés correspondant à au moins une partie ($\mathbf{z}^{[p,1]}$ ; $\mathbf{z}^{[p,2]}$) du signal reçu (**z** ; 401) au moyen des informations a priori (403) ;
un détecteur à boucle (406) destiné à mettre à jour les estimations (403-*l*) des symboles d'information décodés correspondant à la partie ($\mathbf{z}^{[p,1]}$ ; $\mathbf{z}^{[p,2]}$) du signal reçu (**z**; 401) au moyen du signal reçu (**z**; 401) et les informations extrinsèques (405-(*l*-1)) correspondant à la partie ($\mathbf{z}^{[p,1]}$ ; $\mathbf{z}^{[p,2]}$) du signal reçu, et à fournir les estimations (403-*l*) mises à jour au décodeur (404) en tant qu'informations a priori mises à jour pour une itération suivante,
**caractérisé en ce que**
le détecteur à boucle (406) est configuré pour mettre à jour les estimations (403-*l*) des symboles d'information décodés correspondant à différentes parties ($\mathbf{z}^{[p,1]}$ ; $\mathbf{z}^{[p,2]}$) du signal reçu (**z** ; 401) en différentes itérations.

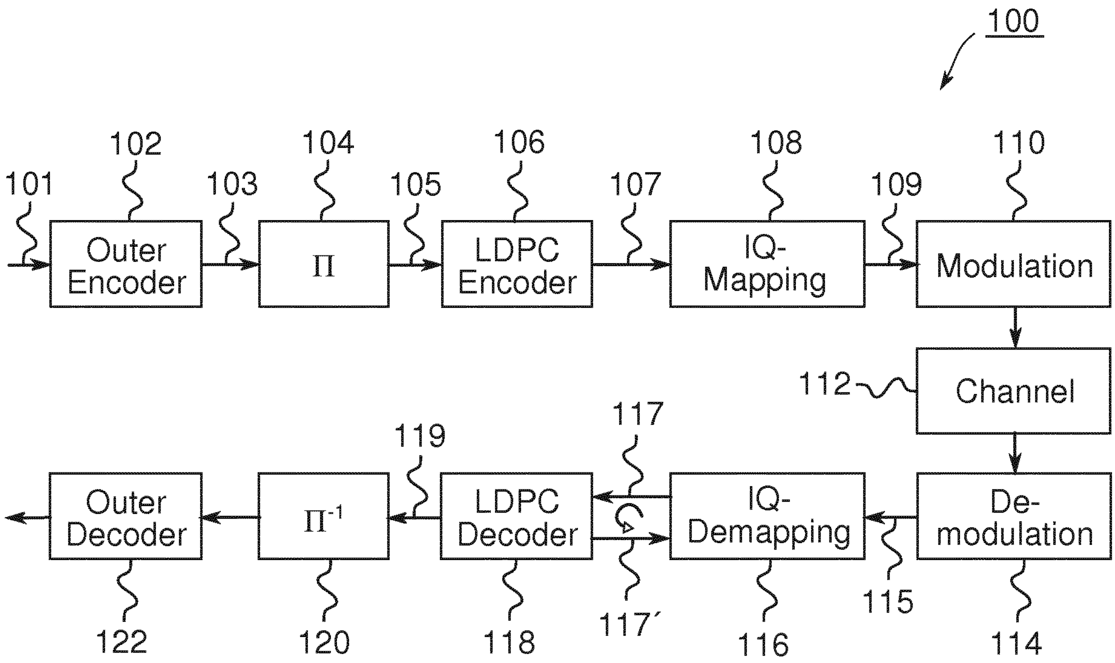
100
101
102
Outer Encoder
103
104
Π
105
106
LDPC Encoder
107
108
IQ-Mapping
109
110
Modulation
112
Channel
De-modulation
114
115
IQ-Demapping
116
117
117´
LDPC Decoder
118
119
Π-1
120
Outer Decoder
122

Fig. 1a

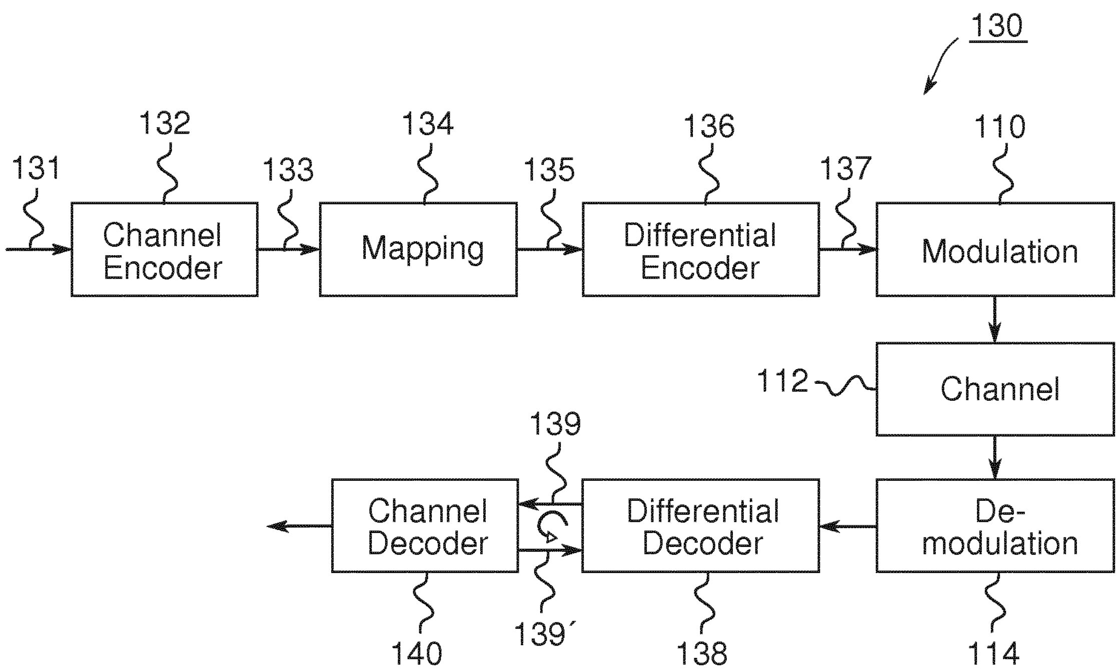
130
131
132
Channel Encoder
133
134
Mapping
135
136
Differential Encoder
137
110
Modulation
112
Channel
De-modulation
114
Differential Decoder
138
139
139´
Channel Decoder
140

Fig. 1b

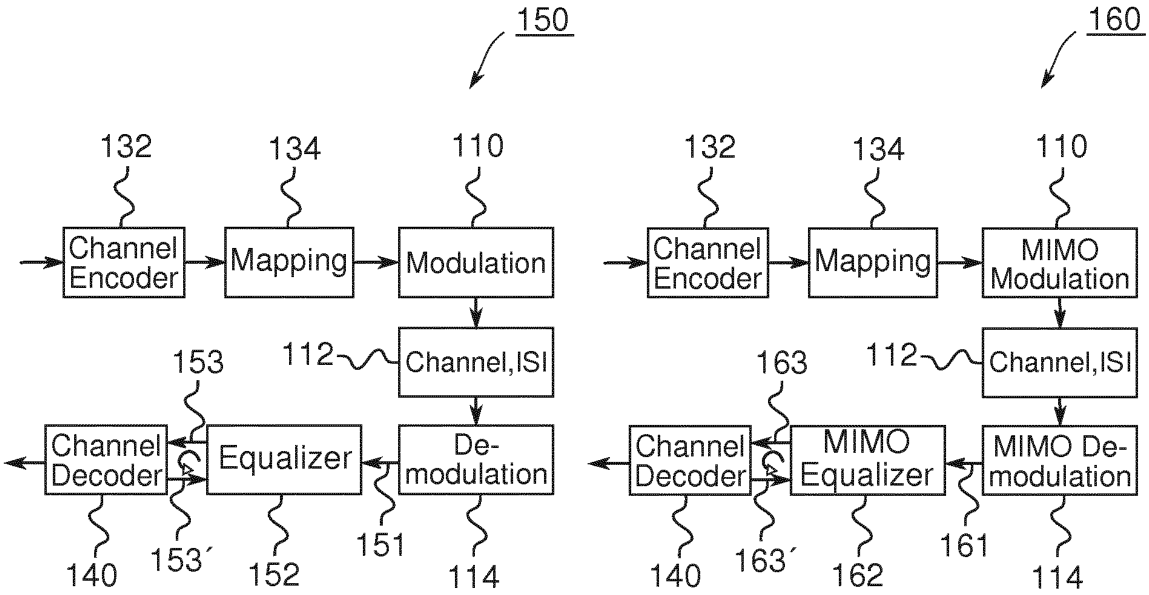
150
160
132
134
110
Channel Encoder
Mapping
Modulation
MIMO Modulation
112
Channel,ISI
153
163
Channel Decoder
Equalizer
De-modulation
MIMO Equalizer
MIMO De-modulation
140
153´
152
151
114
163´
162
161

Fig. 1c

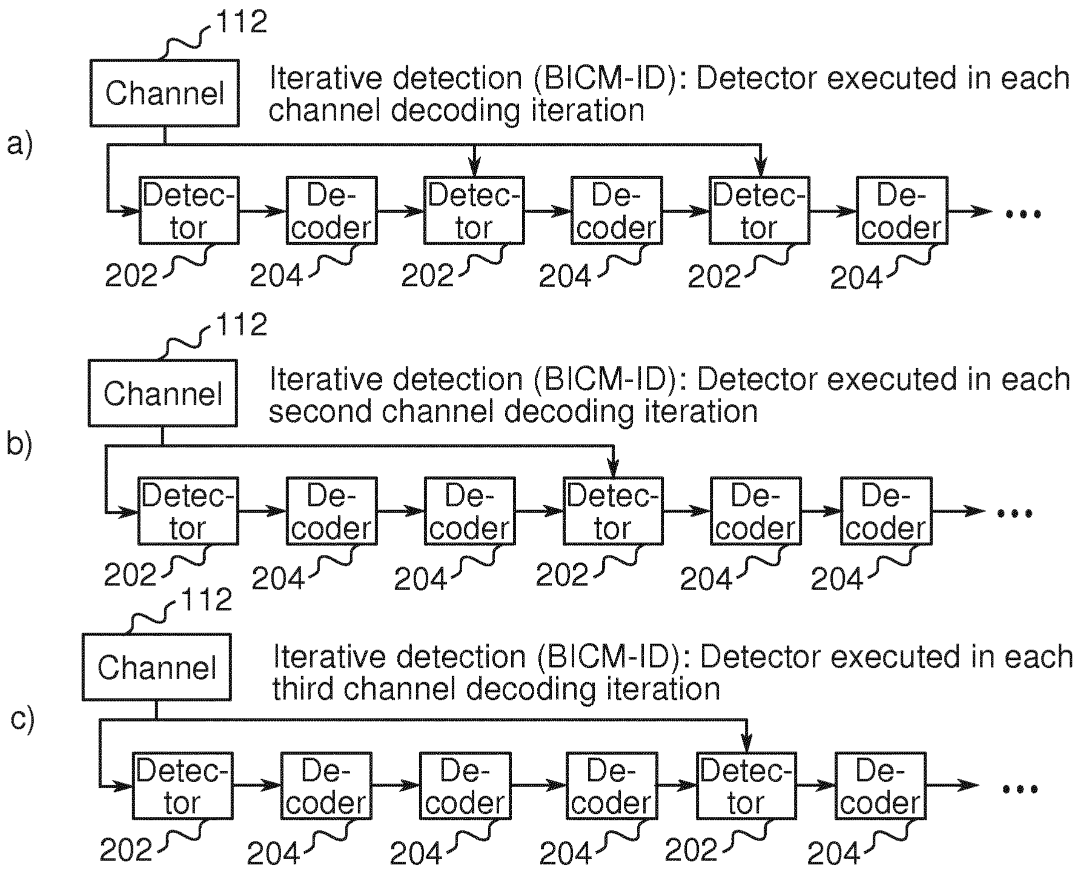
a)
112
Channel
Iterative detection (BICM-ID): Detector executed in each channel decoding iteration
Detec-tor
De-coder
202
204
...
b)
Iterative detection (BICM-ID): Detector executed in each second channel decoding iteration
c)
Iterative detection (BICM-ID): Detector executed in each third channel decoding iteration

Fig. 2

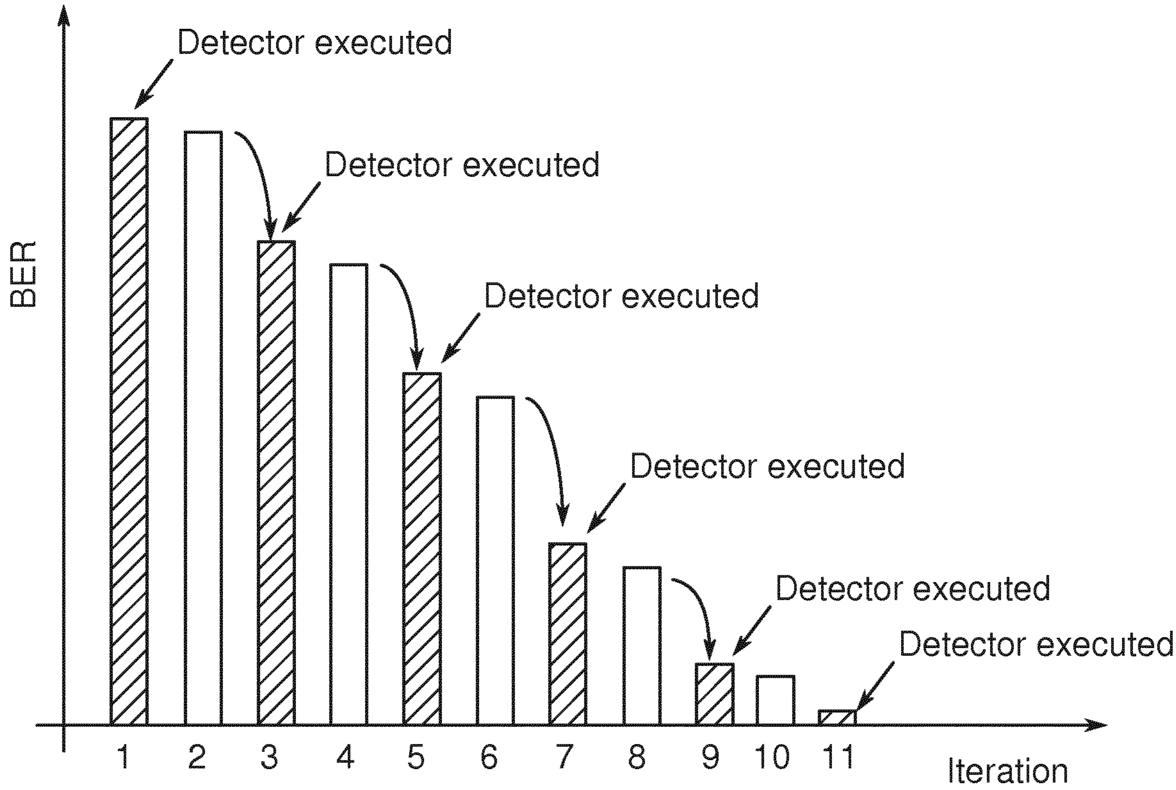
BER
Detector executed
Detector executed
Detector executed
Detector executed
Detector executed
Detector executed
1
2
3
4
5
6
7
8
9
10
11
Iteration

Fig. 3

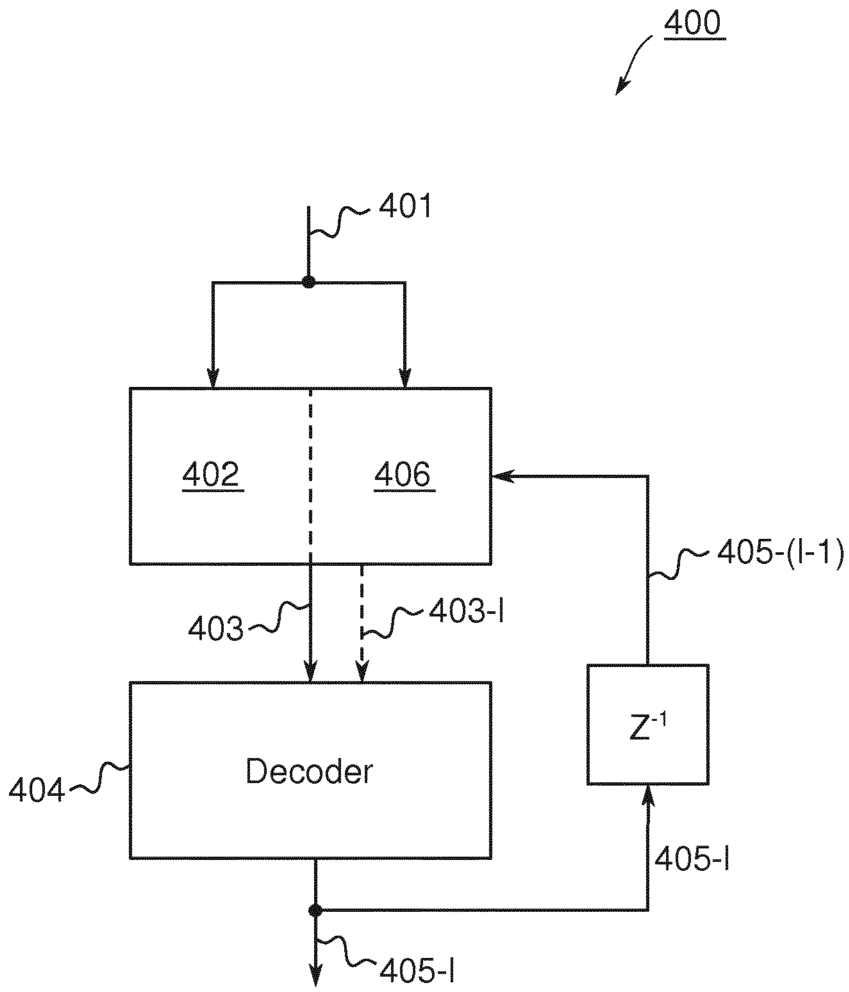


Fig. 4

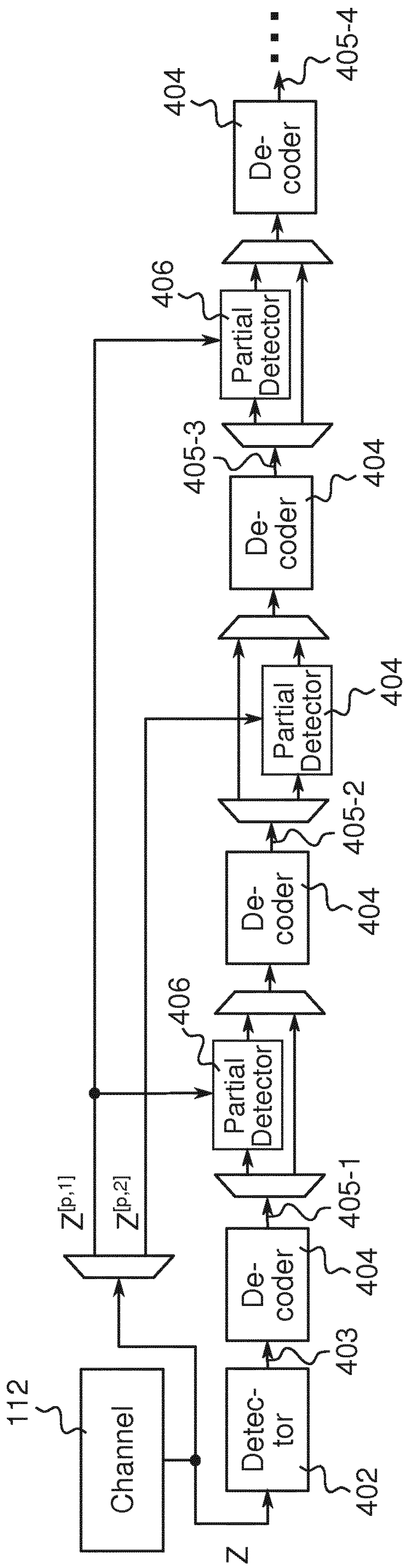
Channel
112
Detec-
tor
402
Z
403
De-
coder
404
405-1
Partial
Detector
406
405-2
405-3
405-4
Z[p,1]
Z[p,2]

Fig. 5a

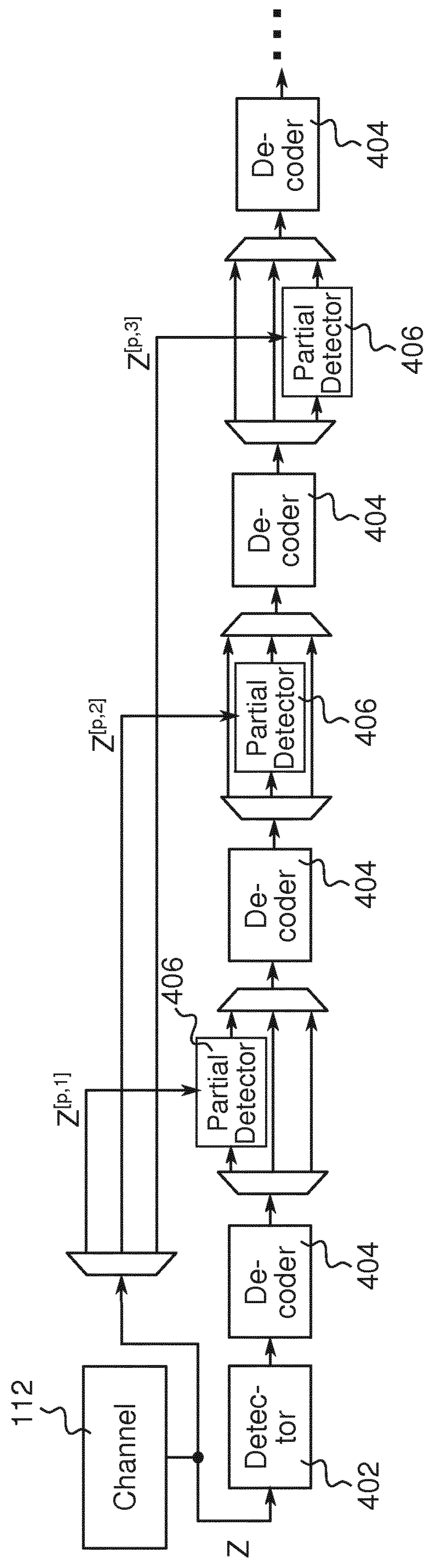
Channel
112
Detec-
tor
402
Z
De-
coder
404
Partial
Detector
406
Z[p,1]
Z[p,2]
Z[p,3]

Fig. 5b

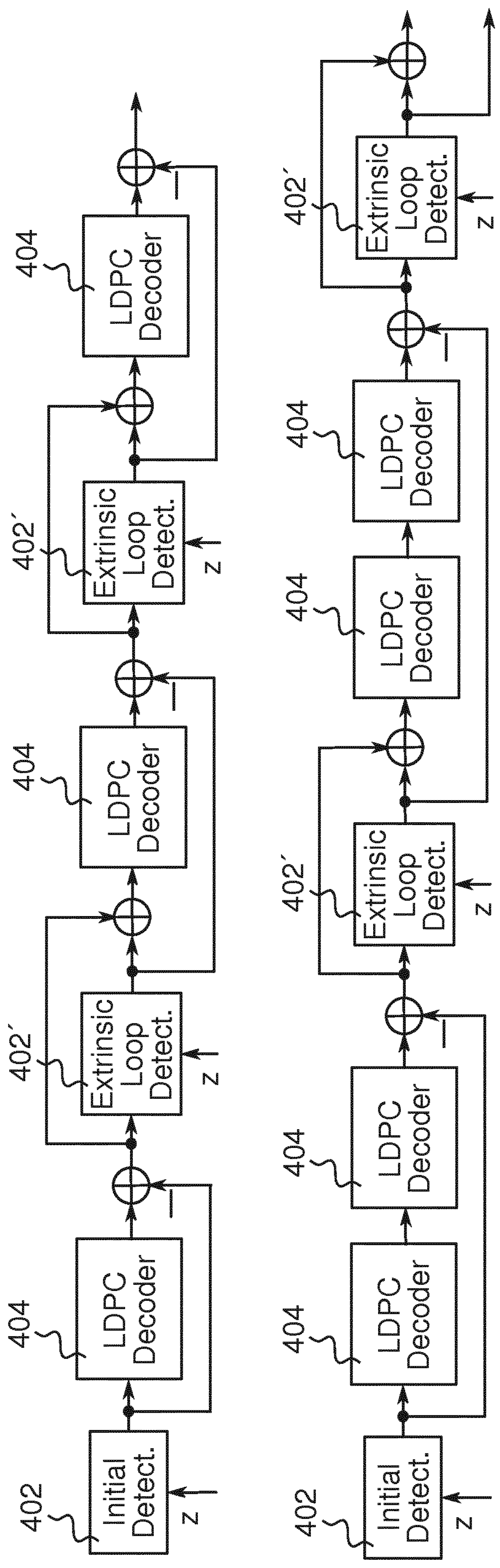
402
Initial Detect.
z
404
LDPC Decoder
402´
Extrinsic Loop Detect.


Fig. 5c

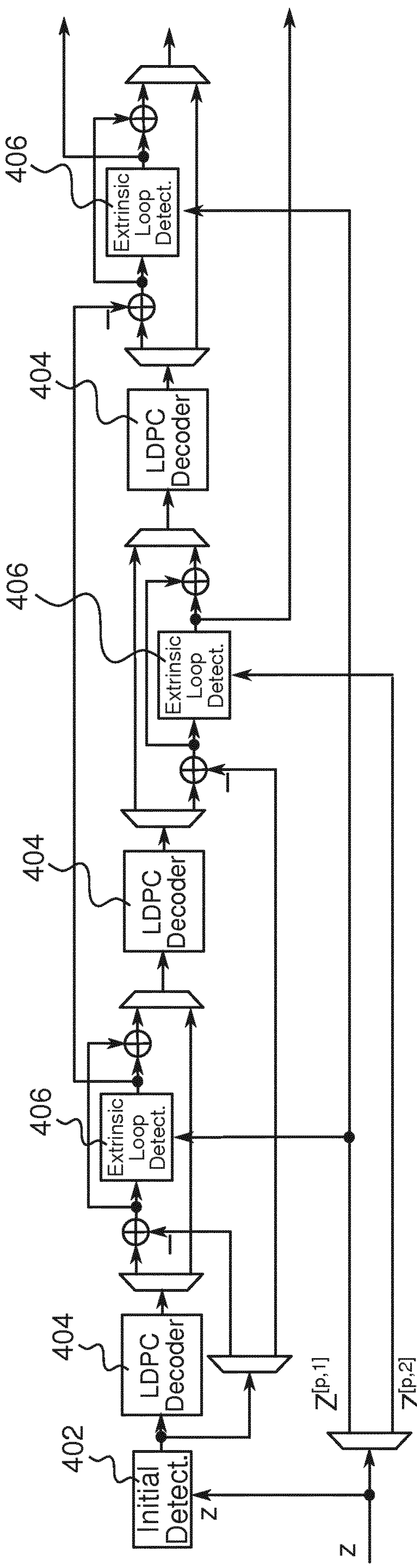
402
Initial Detect.
z
404
LDPC Decoder
406
Extrinsic Loop Detect.
Z[p,1]
Z[p,2]


Fig. 5d

Conventional scheme: Detector executed in every second iteration

| | It.1 | It.2 | It.3 | It.4 | It.5 | It.6 | It.7 |
|---|---|---|---|---|---|---|---|
| $Z_1$ | Initial Detect. | | Det | | Det | | Det |
| $Z_2$ | | | Det | | Det | | Det |

Proposed scheme: Interleaved partial detector execution

| | It.1 | It.2 | It.3 | It.4 | It.5 | It.6 | It.7 |
|---|---|---|---|---|---|---|---|
| $Z_1$ | Initial Detect. | Det | | Det | | Det | |
| $Z_2$ | | | Det | | Det | | Det |

Fig. 6

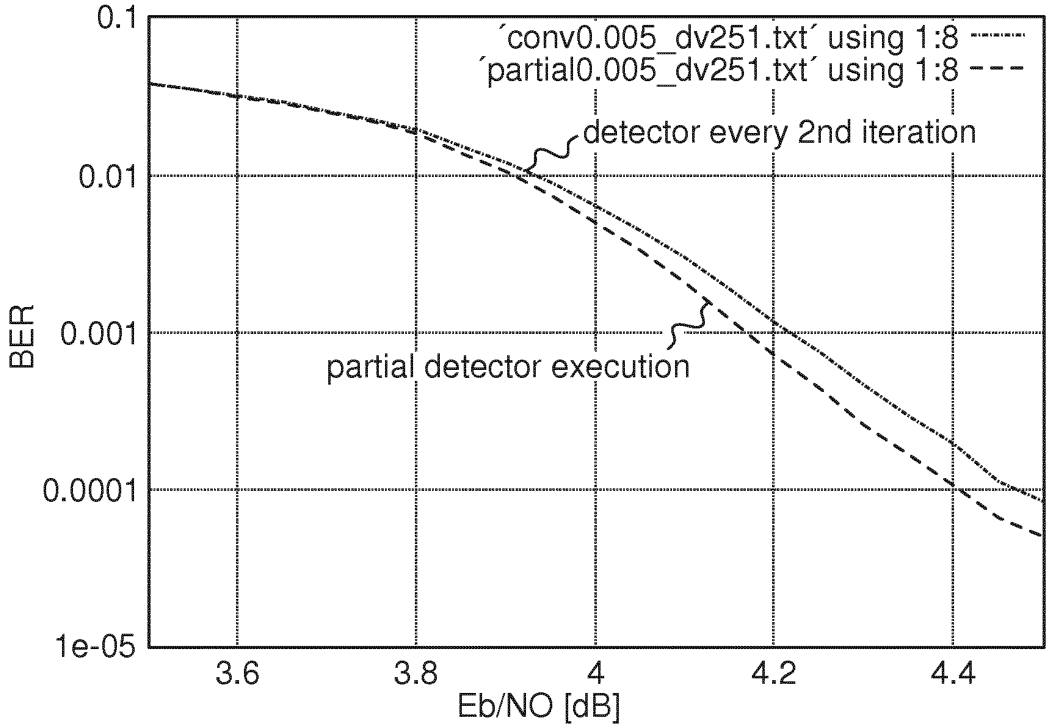
0.1
0.01
0.001
0.0001
1e-05
BER
´conv0.005_dv251.txt´ using 1:8
´partial0.005_dv251.txt´ using 1:8
detector every 2nd iteration
partial detector execution
3.6
3.8
4
4.2
4.4
Eb/NO [dB]

Fig. 7a

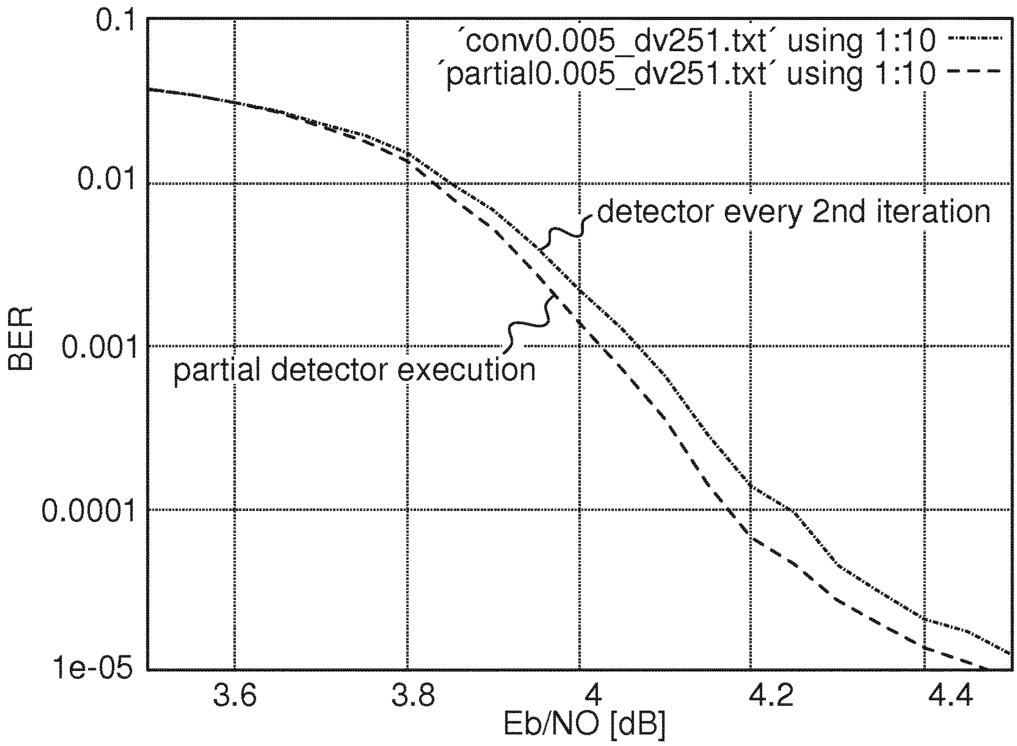
0.1
0.01
0.001
0.0001
1e-05
BER
´conv0.005_dv251.txt´ using 1:10
´partial0.005_dv251.txt´ using 1:10
detector every 2nd iteration
partial detector execution
3.6
3.8
4
4.2
4.4
Eb/NO [dB]

Fig. 7b

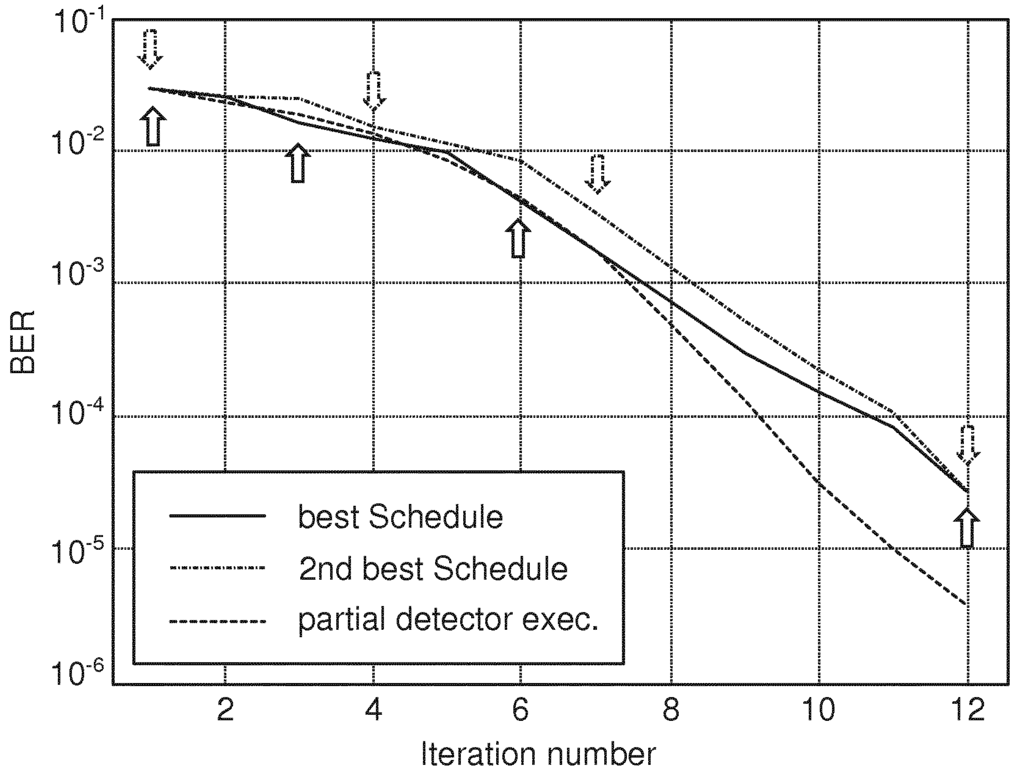
10-1
10-2
10-3
10-4
10-5
10-6
BER
2
4
6
8
10
12
Iteration number
best Schedule
2nd best Schedule
partial detector exec.

Fig. 8a

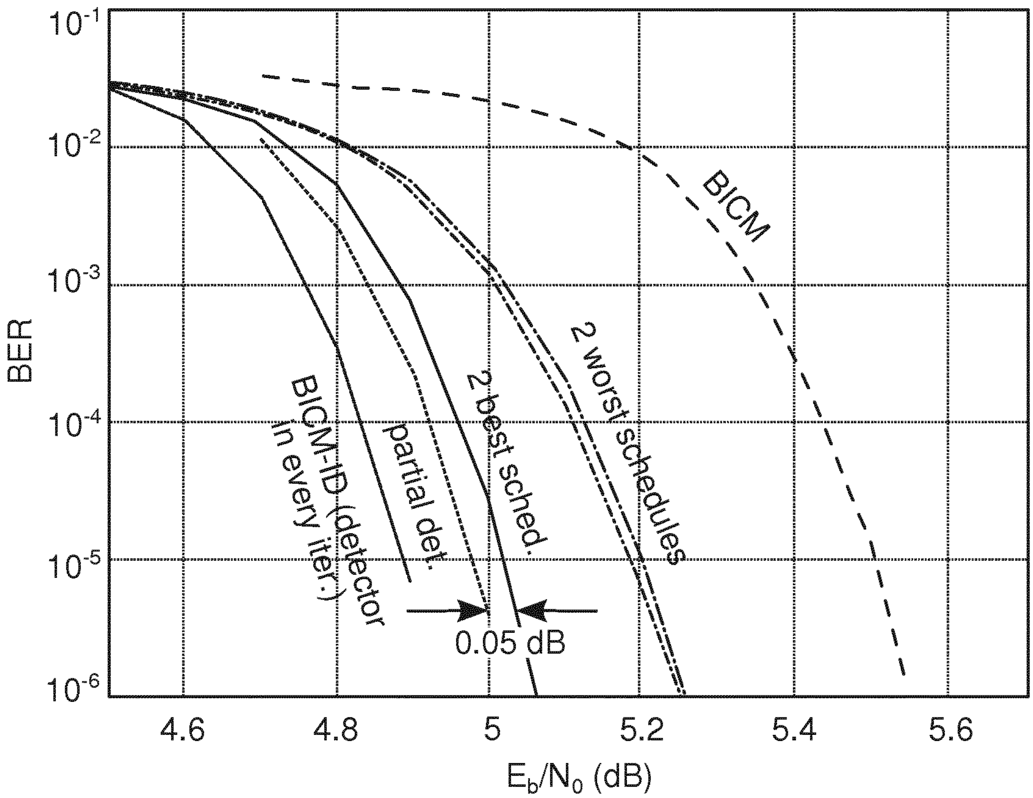
10-1
10-2
10-3
10-4
10-5
10-6
BER
4.6
4.8
5
5.2
5.4
5.6
$E_b/N_0$ (dB)
BICM
2 worst schedules
2 best sched.
partial det.
BICM-ID (detector in every iter.)
0.05 dB

Fig. 8b

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20130262084 A1